(19) **Europäisches Patentamt / European Patent Office / Office européen des brevets**

(11) **EP 3 729 531 B1**

(12) # FASCICULE DE BREVET EUROPEEN

(45) Date de publication et mention de la délivrance du brevet:
**01.09.2021 Bulletin 2021/35**

(21) Numéro de dépôt: **18829334.4**

(22) Date de dépôt: **18.12.2018**

(51) Int Cl.:
*H01L 45/00* *(2006.01)* *H01L 27/24* *(2006.01)*

(86) Numéro de dépôt international:
**PCT/EP2018/085667**

(87) Numéro de publication internationale:
**WO 2019/121796 (27.06.2019 Gazette 2019/26)**

(54) **MEMOIRE RESISTIVE EN TROIS DIMENSIONS ET PROCEDE DE FABRICATION D'UNE TELLE MEMOIRE**

RESISTIVER SPEICHER IN DREI DIMENSIONEN UND VERFAHREN ZUR HERSTELLUNGEN EINES SOLCHEN SPEICHERS

RESISTIVE MEMORY IN THREE DIMENSIONS AND METHOD FOR FABRICATING SUCH A MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2017 FR 1762939**

(43) Date de publication de la demande:
**28.10.2020 Bulletin 2020/44**

(73) Titulaire: **Commissariat à l'Energie Atomique et aux Energies Alternatives
75015 Paris (FR)**

(72) Inventeurs:
- **EL HAJJAM, Khalil**
  **38000 GRENOBLE (FR)**
- **MOLAS, Gabriel**
  **38000 GRENOBLE (FR)**
- **NODIN, Jean-François**
  **38950 QUAIX EN CHARTREUSE (FR)**

(74) Mandataire: **Cabinet Camus Lebkiri
25 rue de Maubeuge
75009 Paris (FR)**

(56) Documents cités:
**WO-A1-2017/111776 WO-A1-2017/131642
WO-A1-2017/160233 US-A1- 2015 340 406**

**Description**

**DOMAINE TECHNIQUE DE L'INVENTION**

Le domaine technique de l'invention est celui des mémoires. La présente invention concerne une mémoire en trois dimensions (ci-après 3D) et en particulier une mémoire en 3D dans laquelle un sélecteur est associé à chaque point mémoire. L'invention concerne également un procédé permettant d'obtenir une telle mémoire.

**ARRIERE-PLAN TECHNOLOGIQUE DE L'INVENTION**

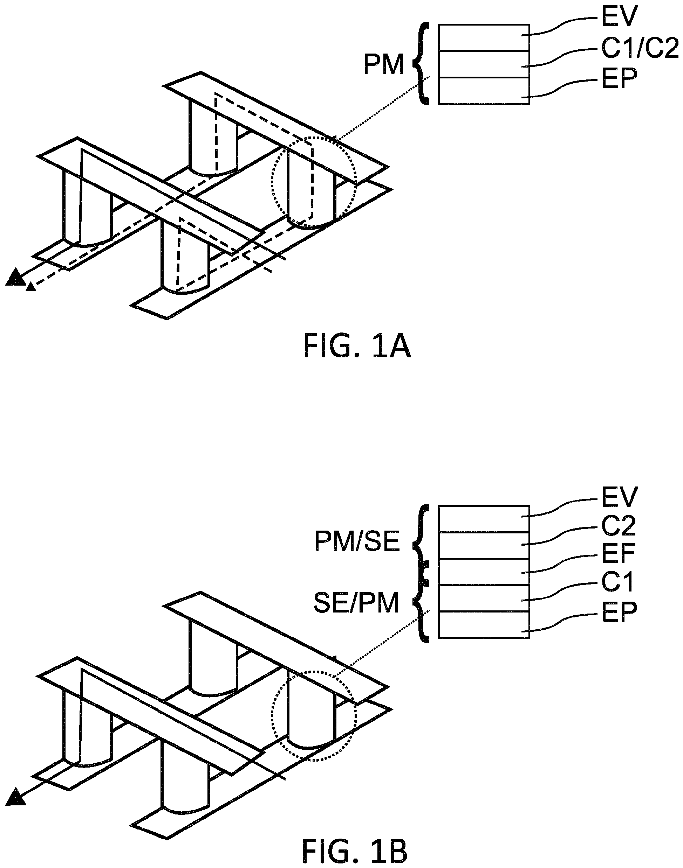

Dans la technologie des mémoires en deux dimensions (ci-après 2D), un problème connu lié à l'adressage d'un point mémoire PM est celui des chemins de fuite. En effet, comme illustré à la figure 1A, lorsque l'on applique un potentiel de lecture sur une ligne et sur une colonne afin de lire un point mémoire PM d'une matrice de points mémoire PM, le courant passe non seulement par le point mémoire PM cible (c'est-à-dire situé à l'intersection de la ligne et de la colonne sélectionnées - flèche en ligne continue), mais également par des chemins parasites (flèches en ligne pointillée) qui peuvent altérer la lecture du point mémoire PM.

Dans les structures 2D, il est aisé de réduire voire supprimer le problème de chemins parasites en insérant un sélecteur SE entre le point mémoire PM et la colonne ou la ligne d'adressage comme cela est illustré figure 1B. Un sélecteur SE est composé d'une électrode flottante EF (c'est-à-dire qu'elle n'est reliée à aucune référence de potentiel lors du fonctionnement de la mémoire) d'un matériau actif C1/C2, en général choisi en fonction du matériau actif C2/C1 utilisé pour le point mémoire PM et d'une électrode EP/EV. Cependant, une telle configuration n'a jusqu'à présent pas été mise en place dans le cas des mémoires en 3D. En effet, dans le cas d'une mémoire en 3D, la mise en place d'un sélecteur SE entrainerait un court-circuit entre les électrodes planes EP, ledit court-circuit étant provoqué par l'électrode flottante EF.

Les documents WO2016160233, WO2017111776, WO2017131642 et US2015340406 divulguent des mémoires résistive en trois dimensions.

Il existe donc un besoin d'une mémoire en 3D comprenant des sélecteurs SE afin de diminuer ou supprimer le problème de chemins de fuite. Il existe également un besoin d'un procédé permettant d'obtenir une telle mémoire.

**RESUME DE L'INVENTION**

L'invention offre une solution aux problèmes évoqués précédemment, en proposant un dispositif mémoire en 3D comprenant un sélecteur pour chaque point mémoire. Pour mémoire, une mémoire 3D est le résultat d'une stratégie d'intégration où les dispositifs sont organisés dans les trois directions de l'espace, et plus uniquement sur un plan horizontal comme dans les mémoires traditionnelles 2D. Cette configuration permet d'améliorer les performances des dispositifs mémoire tout en augmentant la densité de stockage (et donc de réduire les coûts de fabrication). Un premier aspect de l'invention concerne une mémoire en 3D comprenant une pluralité de points mémoire et une pluralité de sélecteurs, chaque point mémoire de la pluralité de points mémoire étant associé à un sélecteur de la pluralité de sélecteurs selon la revendication indépendante de dispositif 1.

Grâce à l'invention, chaque point mémoire est associé à un sélecteur ce qui permet de réduire voire d'éliminer les problèmes de chemins de fuite lors de l'adressage d'un point mémoire à l'aide de l'électrode plane et de l'électrode verticale correspondant audit point mémoire. De plus, chaque point mémoire est associé à un sélecteur dont la géométrie peut être contrôlée en modulant l'épaisseur de la couche du premier matériau actif. En outre, il est possible de moduler la forme de l'extrémité proximale de chaque électrode plane en faisant varier la distance séparant l'extrémité proximale de chacune des sous-couches de l'électrode verticale, ladite distance étant mesurée dans le plan formé par ladite couche ou ladite sous-couche. L'extrémité proximale d'une couche ou d'une sous-couche est l'extrémité de ladite couche ou sous-couche la plus proche de l'électrode verticale considérée.

Outre les caractéristiques qui viennent d'être évoquées dans le paragraphe précédent, la mémoire selon un premier aspect de l'invention peut présenter une ou plusieurs caractéristiques complémentaires parmi les suivantes, considérées individuellement ou selon toutes les combinaisons techniquement possibles. Avantageusement, l'extrémité proximale de la première sous-couche et l'extrémité proximale de la troisième sous-couche sont plus proches de l'électrode verticale que l'extrémité proximale de la deuxième sous-couche de sorte à former un retrait, une partie de l'électrode flottante associée à l'électrode plane considérée s'insérant dans ledit retrait.

Ainsi, il est possible de tirer avantage de l'effet de pointe se produisant à l'extrémité de chaque électrode flottante faisant face à la deuxième couche l'électrode plane qui lui est associée, par exemple pour faciliter la formation d'un filament permettant le stockage d'une information.

Avantageusement, l'extrémité proximale de la première sous-couche et l'extrémité proximale de la troisième sous-couche sont plus éloignées de l'électrode verticale que l'extrémité proximale de la deuxième sous-couche de sorte à former une protubérance.

Ainsi, l'épaisseur de la deuxième sous-couche peut être choisie de sorte que le passage d'un courant provoque un échauffement au niveau de l'extrémité de l'électrode plane considérée au niveau de l'extrémité proximale de la deuxième sous-couche, en particulier lorsque le point mémoire est un point mémoire à changement de phase.

Avantageusement, l'épaisseur de l'électrode flottante est supérieure à l'épaisseur de la deuxième sous-couche de l'électrode plane.

Un deuxième aspect de l'invention concerne un procédé de fabrication d'une mémoire en 3D selon la revendication indépendante de procédé 5 comprenant :

- une première étape de dépôt d'une première couche d'un matériau isolant ;
- une deuxième étape de dépôt d'une première couche d'un matériau conducteur sur la première couche d'un matériau isolant ;

la première étape de dépôt d'une première couche d'un matériau isolant et la deuxième étape de dépôt d'une première couche d'un matériau conducteur étant répétées de sorte à obtenir une pluralité de premières couches d'un matériau isolant et une pluralité de premières couches d'un matériau conducteur, le procédé comprenant également :

- une première étape de gravure anisotrope dans la pluralité de premières couches d'un matériau isolant et dans la pluralité de premières couches d'un matériau conducteur ;
- une première étape de gravure sélective de la pluralité de premières couches d'un matériau conducteur ;
- une quatrième étape de dépôt conforme d'une première couche d'un premier matériau actif ;
- une cinquième étape de dépôt d'une deuxième couche d'un matériau conducteur ;
- une deuxième étape de gravure anisotrope de la troisième couche d'un matériau conducteur et de la première couche d'un premier matériau actif ;
- une sixième étape de dépôt conforme d'une deuxième couche d'un deuxième matériau actif ;
- une septième étape de dépôt d'une troisième couche d'un matériau conducteur.

De plus, la deuxième étape de dépôt d'une première couche d'un matériau conducteur sur la première couche d'un matériau isolant comprend :

- une étape de dépôt d'une première sous-couche dans un premier matériau conducteur de sous-couches ;
- une étape de dépôt d'une deuxième sous-couche dans un deuxième matériau conducteur de sous-couches ;
- une étape de dépôt d'une troisième sous-couche dans un troisième matériau conducteur de sous-couches.

En outre, le matériau de la première sous-couche et le matériau de la troisième sous-couche sont gravés à une vitesse différente de cette à laquelle est gravé le matériau de la deuxième sous-couche lors de la première étape de gravure sélective de la pluralité de premières couches d'un matériau conducteur.

Ainsi, le procédé selon un deuxième aspect de l'invention permet d'obtenir une mémoire en 3D dans laquelle chaque point mémoire est associé à un sélecteur. On entend par une première étape de gravure sélective de la pluralité de premières couches d'un matériau conducteur que lors de cette étape de gravure, la vitesse de gravure de la pluralité de premières couches d'un matériau conducteur est supérieure, préférentiellement largement supérieure, à la vitesse de gravure de la pluralité de premières couches d'un matériau isolant. De plus, il est permis, lors de la fabrication, de contrôler la géométrie de l'extrémité proximale de l'électrode plane et donc du sélecteur et de l'électrode flottante qui lui sont associés. Avantageusement, le premier matériau de la première sous-couche et le troisième matériau de la troisième sous-couche sont gravés à une vitesse inférieure à la vitesse à laquelle est gravé le deuxième matériau de la deuxième sous-couche lors de la première étape de gravure sélective de la pluralité de premières couches d'un matériau conducteur.

Ainsi, l'extrémité proximale de la première sous-couche et l'extrémité proximale de la troisième sous-couche sont plus proches de l'électrode verticale que l'extrémité proximale de la deuxième sous-couche de sorte à former un retrait, une partie de l'électrode flottante pouvant alors s'insérer dans ledit retrait.

Avantageusement, le premier matériau de la première sous-couche et le troisième matériau de la troisième sous-couche sont gravés à une vitesse supérieure à la vitesse à laquelle est gravé le deuxième matériau de la deuxième sous-couche lors de la première étape de gravure sélective de la pluralité de premières couches d'un matériau conducteur.

Ainsi, l'extrémité proximale de la première sous-couche et l'extrémité proximale de la troisième sous-couche sont plus éloignées de l'électrode verticale que l'extrémité proximale de la deuxième sous-couche de sorte à former une protubérance, le premier matériau actif pouvant alors adopter la forme d'un H couché.

Un troisième aspect de l'invention concerne un second procédé de fabrication d'une mémoire en 3D selon la revendication indépendante de procédé 8.

Ainsi, de la même manière que le procédé selon un deuxième aspect de l'invention, le procédé selon un quatrième aspect de l'invention permet d'obtenir une mémoire en 3D dans laquelle chaque point mémoire est associé à un sélecteur.

L'invention est également définit par la revendication indépendante de procédé 9.

Ainsi, de la même manière que le procédé selon un deuxième ou un troisième aspect de l'invention, le procédé selon un quatrième aspect de l'invention permet d'obtenir une mémoire en 3D dans laquelle chaque point mémoire est associé à un sélecteur.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre une représentation schématique d'un dispositif mémoire 2D sans (figure 1A) et avec (figure 1B) sélecteur.
- La figure 2 montre une représentation schématique d'un dispositif mémoire.
- La figure 3 montre une représentation schématique d'un dispositif mémoire.
- La figure 4 montre une représentation schématique d'un dispositif memoire.
- La figure 5 montre un logigramme d'un procédé de fabrication selon un deuxième aspect de l'invention.
- La figure 6 montre un logigramme d'une étape du procédé de fabrication selon un deuxième aspect de l'invention.
- La figure 7 montre une représentation schématique des différentes étapes d'un premier mode de réalisation d'un procédé selon un deuxième aspect de l'invention.
- La figure 8 montre une représentation schématique des différentes étapes d'un deuxième mode de réalisation d'un procédé selon un deuxième aspect de l'invention.
- La figure 9 montre une représentation schématique des différentes étapes d'un troisième mode de réalisation d'un procédé selon un deuxième aspect de l'invention.
- La figure 10 montre un logigramme d'un procédé de fabrication selon un troisième aspect de l'invention.
- La figure 11 montre une représentation schématique des différentes étapes d'un premier mode de réalisation d'un procédé selon un troisième aspect de l'invention.
- La figure 12 montre un logigramme d'un procédé de fabrication selon un quatrième aspect de l'invention.
- La figure 13 montre une représentation schématique des différentes étapes d'un deuxième mode de réalisation d'un procédé selon un quatrième aspect de l'invention.
- La figure 14 illustre deux configurations possibles pour les électrodes verticales dans le cas d'un dispositif comportant une pluralité d'électrodes verticales.
- La figure 15 illustre les deux configurations possibles de tranchés dans un procédé selon un troisième ou un quatrième aspect de l'invention.

## DESCRIPTION DETAILLEE D'AU MOINS UN MODE DE REALISATION DE L'INVENTION

Sauf précision contraire, un même élément apparaissant sur des figures différentes présente une référence unique.

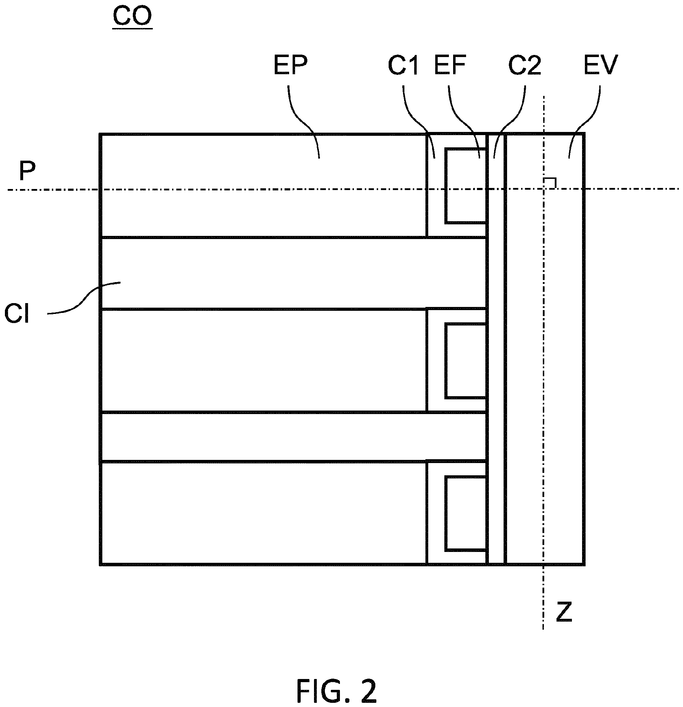

Les figures 2 à 4 concerne une mémoire CO en 3D comprenant une pluralité de points mémoire PM et une pluralité de sélecteurs, chaque point mémoire de la pluralité de points mémoire étant associé à un sélecteur de la pluralité de sélecteurs. Plus particulièrement, dans un mode de réalisation, la mémoire CO en 3D selon un premier aspect de l'invention comprend une pluralité de premières électrodes EP dans un matériau conducteur, dite électrode plane EP, chaque électrode plane EP de la pluralité d'électrodes planes EP définissant un plan P. La mémoire comprend également une deuxième électrode EV dans un matériau conducteur, dite électrode verticale EV, s'étendant essentiellement selon un axe perpendiculaire au plan défini par chaque électrode plane EP de la pluralité d'électrodes planes EP. La mémoire en 3D selon un premier aspect de l'invention comprend également une pluralité de troisièmes électrodes EF, dite électrode flottante dans un matériau conducteur, chaque électrode flottante EF de la pluralité d'électrodes flottantes EF étant située entre une électrode plane EP de la pluralité d'électrodes planes EP et l'électrode verticale EV. Autrement dit, à chaque électrode flottante EF de la pluralité d'électrodes flottantes EF est associée une et une seule électrode plane EP de la pluralité d'électrodes planes EP. Les matériaux conducteurs de l'électrode verticale EV, de l'électrode plane EP et de l'électrode flottante EF peuvent être choisis parmi le TiN, TaN, TaCN, Ta, Ti, W, Cu, Al et/ou Ag. La mémoire en 3D selon l'invention comprend également une pluralité de premières couches CI d'un matériau isolant, chaque électrode plane EP de la pluralité d'électrodes planes EP étant séparée de l'électrode plane EP précédente et/ou suivante par une première couche CI d'un matériau isolant de la pluralité de premières couches CI d'un matériau isolant. La mémoire comprend également une pluralité de première couche C1 d'un premier matériau actif, chaque couche C1 d'un premier matériau actif de la pluralité de couches C1 d'un matériau actif séparant une électrode plane de la pluralité d'électrodes planes EP de l'électrode flottante qui lui est associée. La mémoire en 3D selon l'invention comprend également une deuxième couche C2 d'un deuxième matériau actif séparant l'électrode verticale EV de chaque électrode flottante EF de la pluralité d'électrodes flottantes EF. En d'autres termes, chaque électrode plane EP est séparée de l'électrode flottante EF qui lui est associée par une première couche C1 d'un premier matériau actif, chaque électrode flottante EF de la pluralité d'électrodes flottantes EF est séparée de l'électrode verticale EV par une deuxième couche C2 d'un deuxième matériau actif et chaque électrode plane EP de la pluralité d'électrodes planes EP est séparée des électrodes planes EP adjacentes par une couche CI d'un matériau isolant, dite couche isolante CI.

De plus, le premier matériau actif constituant la première couche C1 d'un matériau actif est apte à former un sélecteur SE (respectivement, un point mémoire PM)

et le deuxième matériau actif constituant la deuxième couche C2 d'un matériau actif est apte à former un point mémoire PM (respectivement, un sélecteur SE). Autrement dit, lorsque le premier matériau actif est choisi de sorte à former un point mémoire PM alors le deuxième matériau actif est choisi de sorte à pouvoir former un sélecteur SE. De la même manière, lorsque le premier matériau actif est choisi de sorte à former un sélecteur SE alors le deuxième matériau actif est choisi de sorte à pouvoir former un point mémoire PM. Le matériau utilisé pour obtenir un sélecteur peut notamment comprendre du $VO_x$, GeSe, $TiO_x$, $TaxO_y$. Le matériau utilisé pour obtenir un point mémoire peut notamment comprendre $HfO_x$, $Al_xO_y$, $Ta_xO_y$, CuTeGe, GST, $TiO_x$, $SiO_x$. Par exemple, le premier matériau actif (respectivement le deuxième matériau actif) est du GeSe alors que le deuxième matériau actif (respectivement le premier matériau actif) est du GST (GeSbTe). L'électrode verticale EV est de préférence de forme cylindrique, encore plus préférentiellement, un cylindre circulaire droit. Pour mémoire, un cylindre est une surface réglée dont les génératrices sont parallèles. La largeur (ou le diamètre pour le cylindre circulaire droit) de l'électrode verticale EV est limitée par la hauteur dudit cylindre et des procédés de fabrication utilisés. En particulier, l'aspect de forme maximum autorisé par un procédé donné permettra de connaitre le diamètre minimum de l'électrode verticale EV en fonction de la hauteur de cette dernière. Ainsi, on obtient une pluralité de points mémoire PM comprenant chacun un sélecteur SE. Dans la suite, on entend par point mémoire PM l'ensemble constitué par deux électrodes (par exemple l'électrode plane EP et l'électrode flottante EF ou l'électrode flottante EF et l'électrode verticale EV) entourant un matériau actif (par exemple la première couche C1 d'un premier matériau actif ou la deuxième couche C2 d'un deuxième matériau actif) apte à former un point mémoire PM. De manière similaire, on entend par sélecteur SE l'ensemble constitué par deux électrodes entourant un matériau actif apte à former un sélecteur SE. Préférentiellement, afin de diminuer le couplage capacitif entre les électrodes planes EP de la pluralité d'électrodes planes EP, l'épaisseur de la couche CI d'un matériau isolant est comprise entre 20 et 40 nm. De préférence, l'épaisseur de la couche isolant CI est en $SiO_2$ afin de tirer parti de sa faible permittivité. Comme cela est illustré aux figures 2 à 4, la couche isolante CI sépare également la structure formée par l'électrode flottante EF et la première couche C1 d'un matériau actif associée à une électrode plane EP des structures identiques associées aux électrodes planes EP adjacentes.

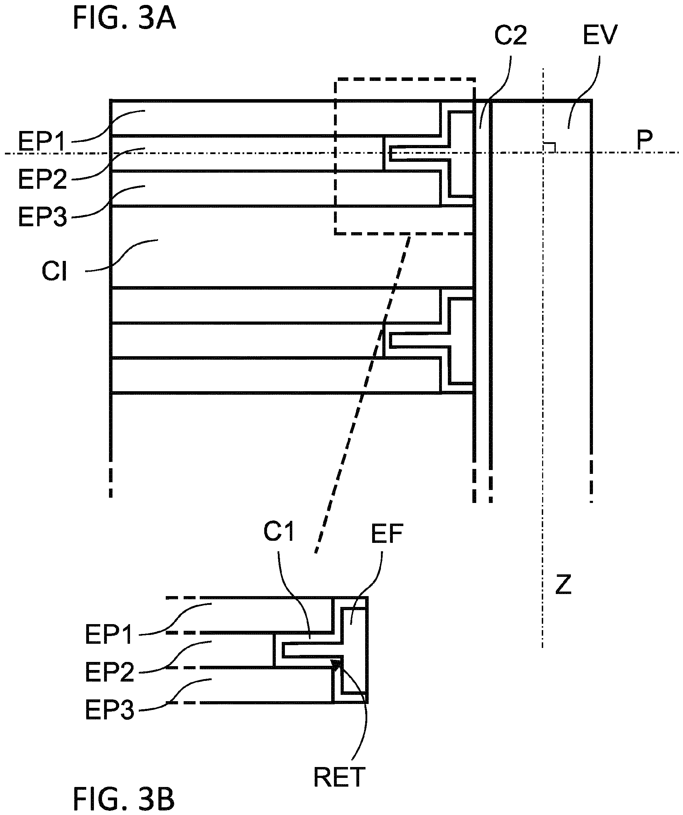

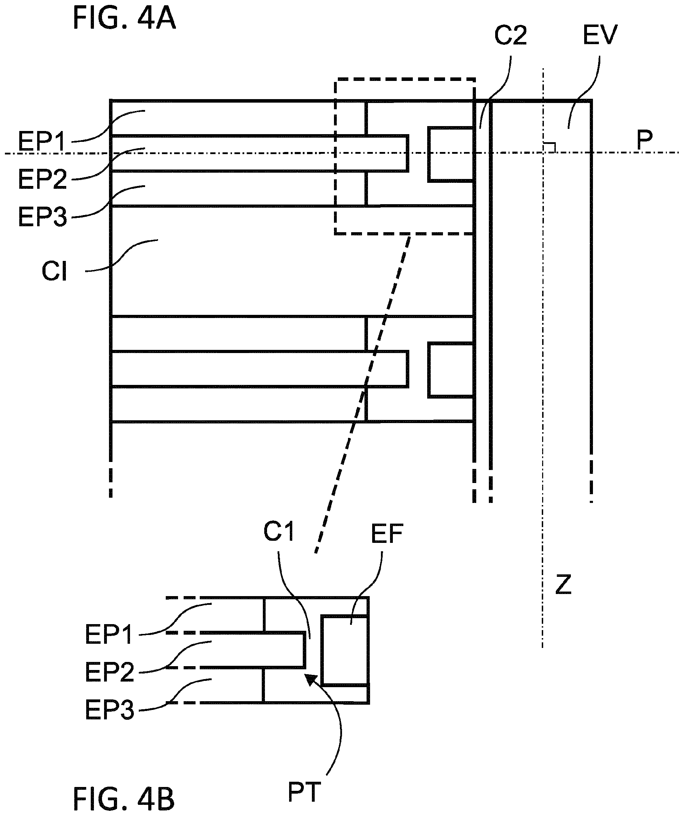

Dans l'invention illustré aux figures 3 et 4, chaque électrode plane EP comprend une première sous-couche EP1 dans un premier matériau conducteur de sous-couche, une deuxième sous-couche EP2 dans un deuxième matériau conducteur de sous-couche et une troisième sous-couche EP3 dans un troisième matériau conducteur de sous-couche. De préférence, les matériaux conducteurs de la première sous-couche EP1 et de la troisième sous-couche EP3 sont identiques. Comme cela sera détaillé dans la suite, cette structure en sous-couche permet de moduler la forme de l'extrémité de l'électrode plane EP. En faisant varier cette forme, il est notamment possible de faire varier la surface de l'électrode plane EP en regard de l'électrode flottante EF qui lui est associée par rapport à la surface de ladite électrode flottante EF en regard de l'électrode verticale EV de sorte à tenir compte des différences de conductivité entre la première couche C1 d'un premier matériau actif et la deuxième couche C2 d'un deuxième matériau actif. Par exemple, la forme de l'électrode plane EP est choisie de sorte que :

$$S_{EP/EF}\rho_{C1} = S_{EF/EV}\rho_{C2}$$

où $S_{EP/EF}$ est la surface de l'électrode plane EP en regard de l'électrode flottante EF qui lui est associée, $S_{EF/EV}$ est la surface de ladite électrode flottante EF en regard de l'électrode verticale EV, $\rho_{C1}$, est la conductivité du premier matériau actif et $\rho_{C2}$ est la conductivité du deuxième matériau actif.

Dans un mode de réalisation illustré aux figures 3A et 3B, pour chaque électrode plane EP de la pluralité d'électrodes planes EP, l'extrémité proximale de la première sous-couche EP1 et l'extrémité proximale de la troisième sous-couche EP3 sont plus proches de l'électrode verticale EV que l'extrémité proximale de la deuxième sous-couche EP2 de sorte à former un retrait RET, une partie de l'électrode flottante EF associée à l'électrode plane EP considérée s'insérant dans ledit retrait RET. L'électrode flottante EF peut par exemple adopter la forme d'un T couché de sorte que la partie de l'électrode flottante EF correspondant au pied de la forme en T s'insère dans le retrait RET. On notera que, dans cette configuration, la hauteur de l'électrode flottante EF en regard de l'électrode verticale EV est supérieure à la hauteur de l'électrode flottante EF en regard de la deuxième couche EP2 de l'électrode plane EP. Le matériau actif de la première couche C1 d'un matériau actif est préférentiellement un matériau apte à former un point mémoire. Ainsi, il est possible de tirer avantage de la forme de T inversé et en particulier de l'effet de pointe se produisant à l'extrémité de l'électrode flottante EF faisant face à la deuxième couche EP2 l'électrode plane EP, par exemple pour faciliter la formation d'un filament permettant le stockage d'une information.

Dans un mode de réalisation alternatif illustré aux figures 4A et 4B, pour chaque électrode plane EP de la pluralité d'électrodes planes EP, l'extrémité proximale de la première sous-couche EP1 et l'extrémité proximale de la troisième sous-couche EP3 sont plus éloignées de l'électrode verticale EV que l'extrémité proximale de la deuxième sous-couche EP2 de sorte à former une protubérance PRT. Préférentiellement, l'épaisseur de l'électrode flottante EF associée à l'électrode plane EP considérée est supérieure à l'épaisseur de la deuxième sous-couche EP2 de l'électrode plane EP. Ainsi, l'extrémité de l'électrode plane EP est affinée ce qui permet favoriser l'échauffement de ladite extrémité, et donc présente un avantage lorsque le point mémoire PM est un point mémoire PM à changement de phase.

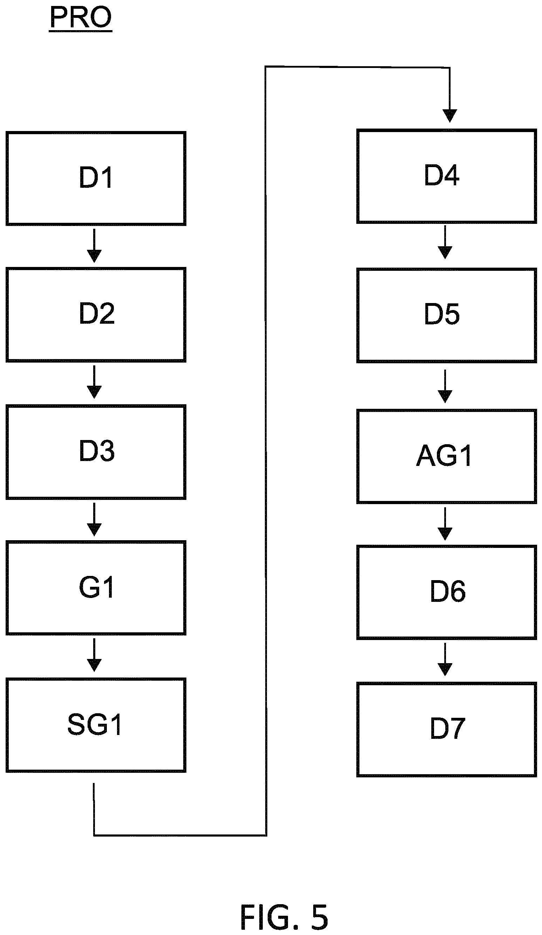

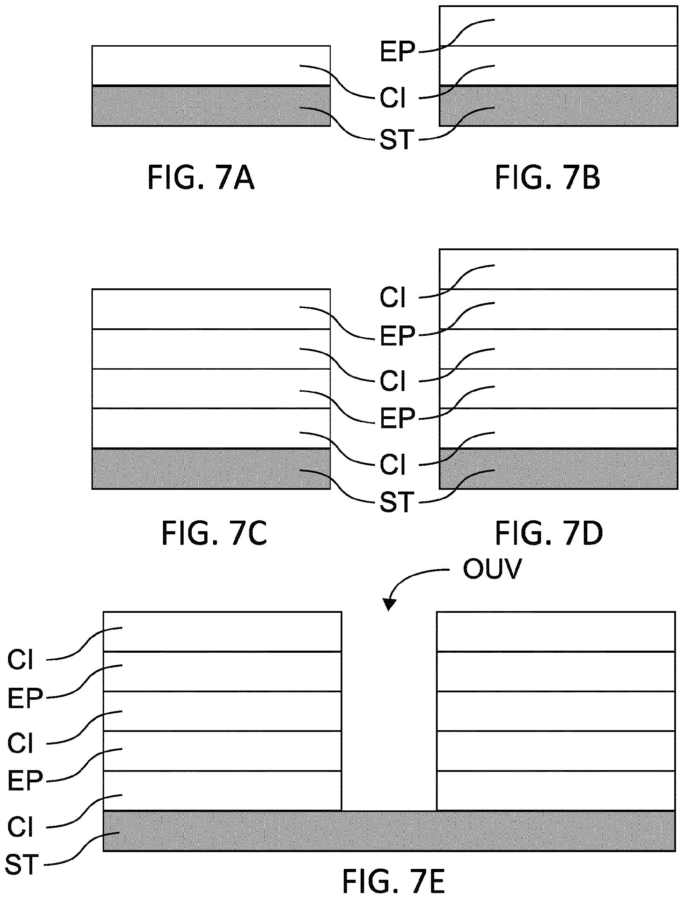

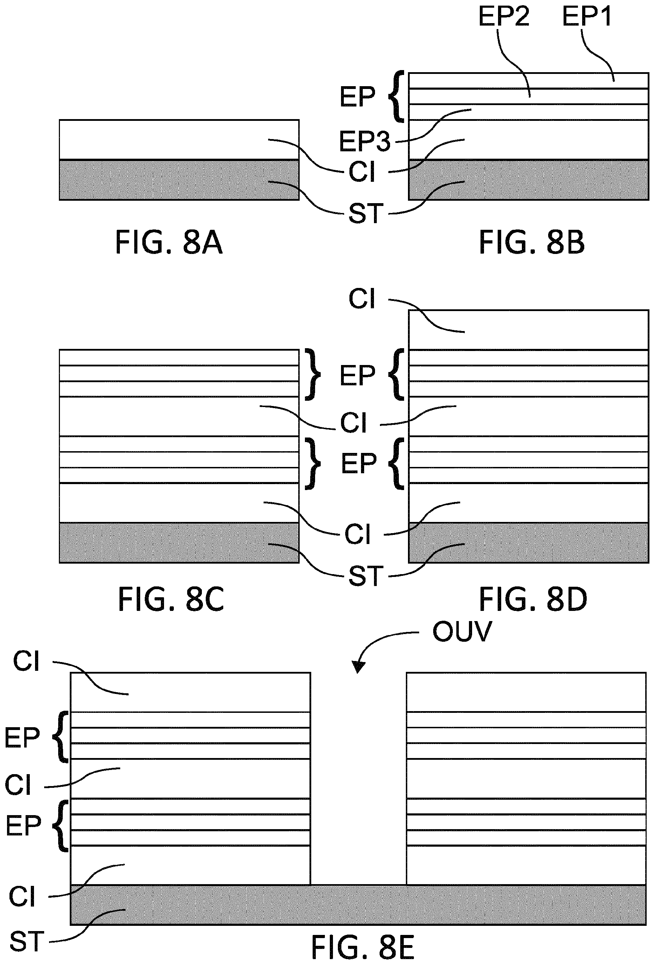

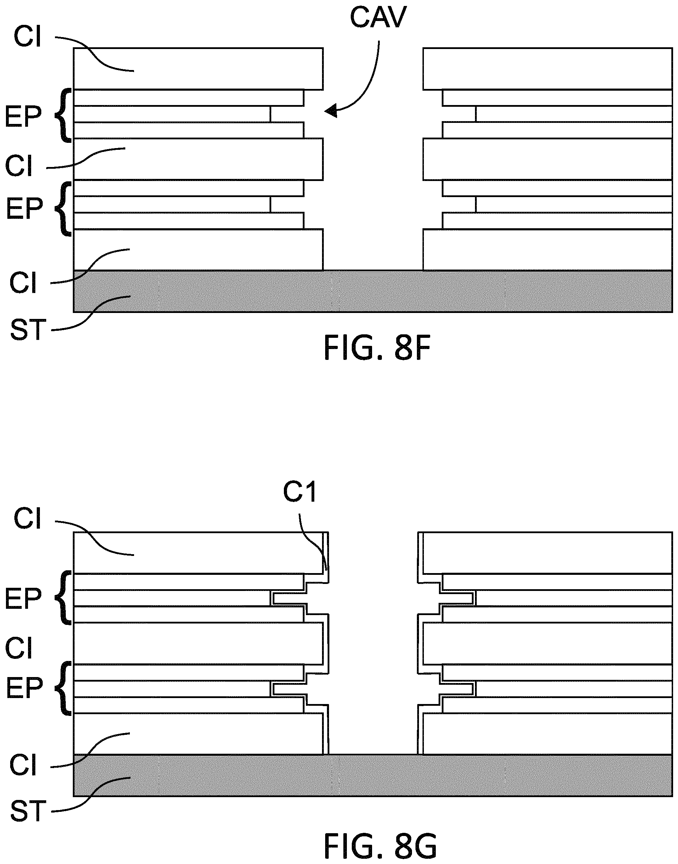

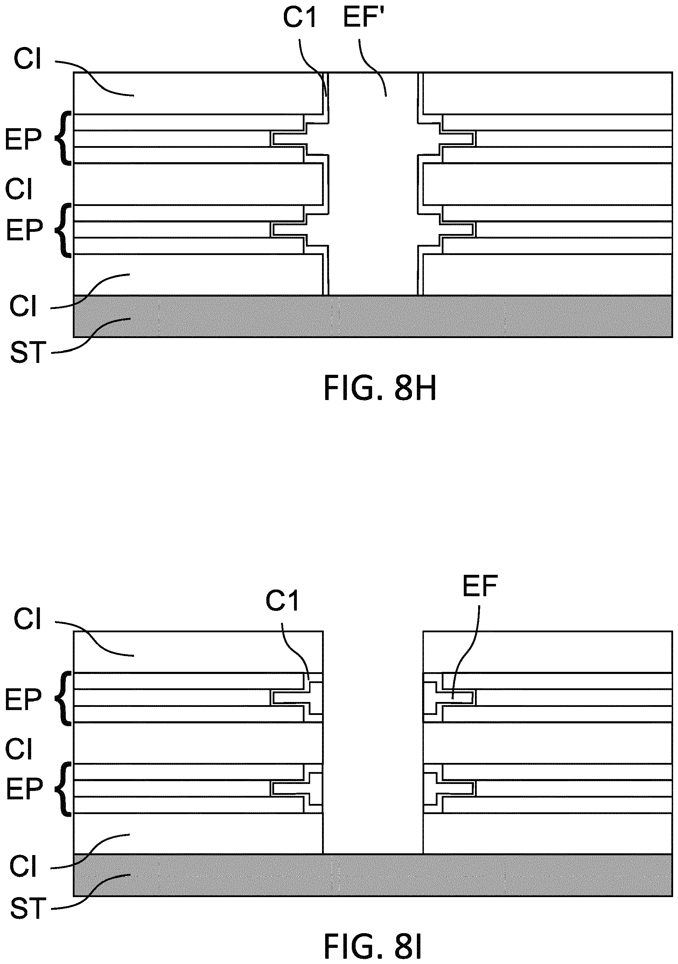

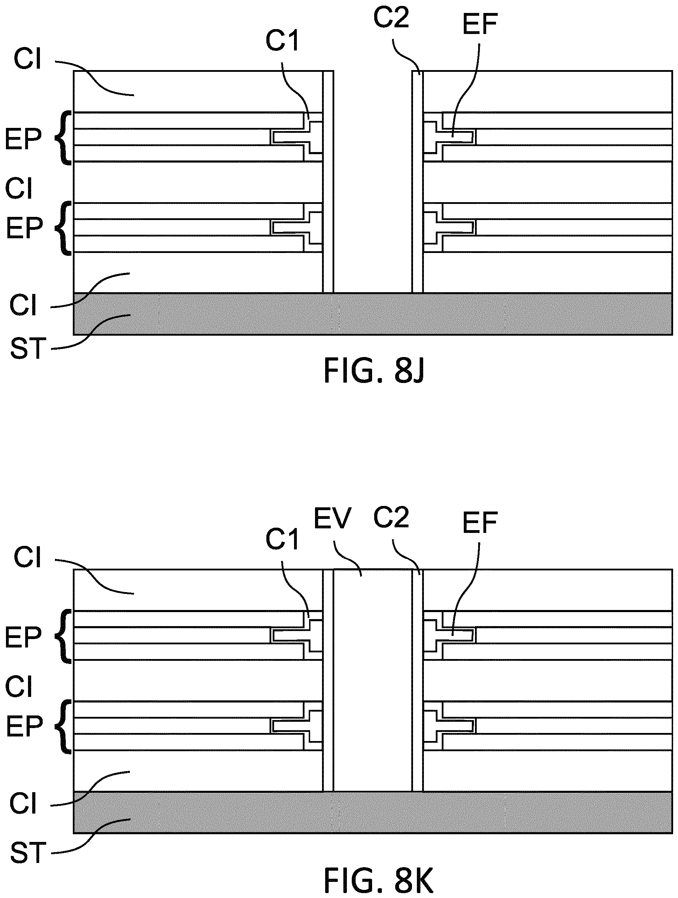

Afin d'obtenir une telle mémoire CO, un second aspect de l'invention illustré aux figures 5 à 9 concerne un procédé PRO de fabrication d'une mémoire en 3D. Comme illustré aux figures 7A et 8A, le procédé PRO selon l'invention comprend une première étape D1 de dépôt d'une première couche CI d'un matériau isolant. Le dépôt peut par exemple être effectué sur un substrat ST semi-conducteur, par exemple un substrat de silicium. Le matériau isolant peut être notamment choisi parmi le SiN et SiO$_x$. Comme illustré aux figures 7B et 8B, le procédé PRO comprend également une deuxième étape D2 de dépôt d'une première couche EP d'un matériau conducteur sur la première couche CI d'un matériau isolant. Le matériau conducteur peut être notamment choisi parmi le TiN, TaN, TaCN, Ta, Ti, W, Cu, Al et/ou Ag. Comme illustré aux figures 7C et 8C, la première étape D1 de dépôt d'une première couche CI d'un matériau isolant et la deuxième étape D2 de dépôt d'une première couche EP d'un matériau conducteur sont répétées, par exemple un nombre N de fois pour obtenir N points mémoire PM par électrode verticale EV, de sorte à obtenir une pluralité de premières couches CI d'un matériau isolant et une pluralité de premières couches EP d'un matériau conducteur. Comme illustré aux figures 7D et 8D, le procédé PRO selon l'invention peut avantageusement comprendre une troisième étape D3 de dépôt d'une deuxième couche CI d'un matériau isolant sur la dernière première couche EP d'un matériau conducteur de la pluralité de premières couches EP d'un matériau conducteur. Le matériau isolant peut être notamment choisi parmi le SiN et SiO$_x$.

Une fois l'empilement illustré aux figures 7D et 8D obtenu, le procédé PRO selon l'invention comprend également, comme illustré aux figures 7E et 8E, une première étape AG1 de gravure anisotrope dans la pluralité de premières couches CI d'un matériau isolant, dans la deuxième couche CI d'un matériau isolant (si cette dernière existe) et dans la pluralité de premières couches EP d'un matériau conducteur de sorte à obtenir une ouverture OUV. Si nécessaire, cette gravure peut être effectuée en plusieurs sous-étapes, en fonction des matériaux utilisés pour les couches d'un matériau isolant ou conducteur.

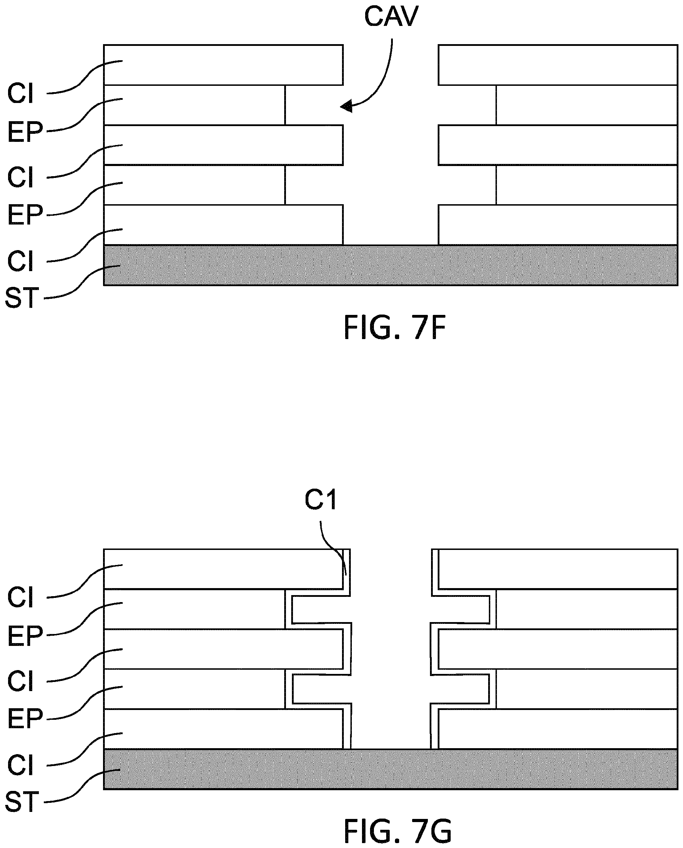

Comme illustré aux figures 7F, 8F et 9A, le procédé comprend ensuite une première étape SG1 de gravure sélective de la pluralité de premières couches EP d'un matériau conducteur. La gravure étant sélective, la pluralité de premières couches CI d'un matériau isolant est gravée moins vite que la pluralité de premières couches EP d'un matériau conducteur formant l'électrode plane EP de sorte qu'une cavité CAV est formée au niveau de chaque électrode plane EP. Comme illustré aux la figure 7G, 8G et 9B, la première étape SG1 de gravure sélective est suivie d'une quatrième étape D4 de dépôt conforme d'une première couche C1 d'un premier matériau actif. Lorsque le premier matériau actif est destiné à jouer le rôle de sélecteur, ce dernier peut notamment être choisi parmi le VO$_x$, GeSe, TiO$_x$ et/ou TaxO$_y$. Lorsque ce premier matériau actif est destiné à jouer le rôle de point mémoire, ce dernier peut notamment être choisi parmi le HfO$_x$, Al$_x$O$_y$, Ta$_x$O$_y$, CuTeGe, GST, TiOx et/ou SiOx.

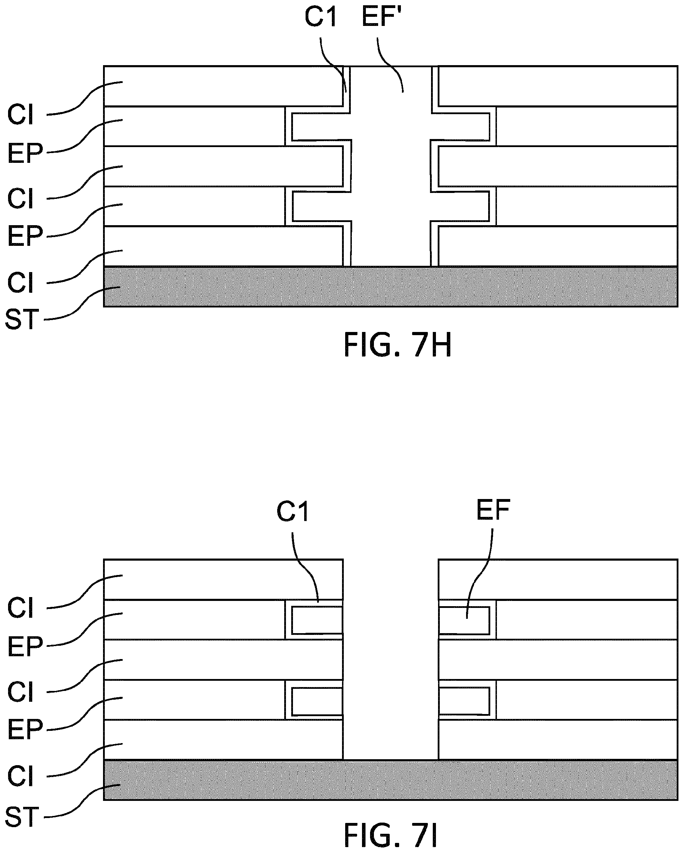

Comme illustré aux figures 7H, 8H et 9C, le procédé selon l'invention comprend également une cinquième étape D5 de dépôt d'une deuxième couche EF' d'un matériau conducteur. Le matériau conducteur peut être choisi parmi le TiN, TaN, TaCN, Ta, Ti, W, Cu, Al et/ou Ag. Sur les figure 7H, 8H et 9C, la deuxième couche EF' d'un matériau conducteur est représentée comme remplissant la totalité de l'ouverture OUV obtenue lors de la première étape AG1 de gravure anisotrope, mais il ne s'agit pas d'une obligation, la deuxième couche EF' d'un matériau conducteur devant en revanche remplir la totalité de chaque cavité CAV.. Comme illustré aux figures 7I, 8I et 9D, cette étape est suivie d'une deuxième étape AG2 de gravure anisotrope de la deuxième couche EF' d'un matériau conducteur et de la première couche C1 d'un matériau actif. La gravure anisotrope permet de conserver la partie de la deuxième couche EF' d'un matériau conducteur et la partie de la première couche C1 d'un matériau actif présentes dans la cavité CAV au niveau de chaque électrode plane EP de sorte à former, pour chaque électrode plane EP une électrode flottante EF et le matériau actif du sélecteur SE ou du point mémoire PM.

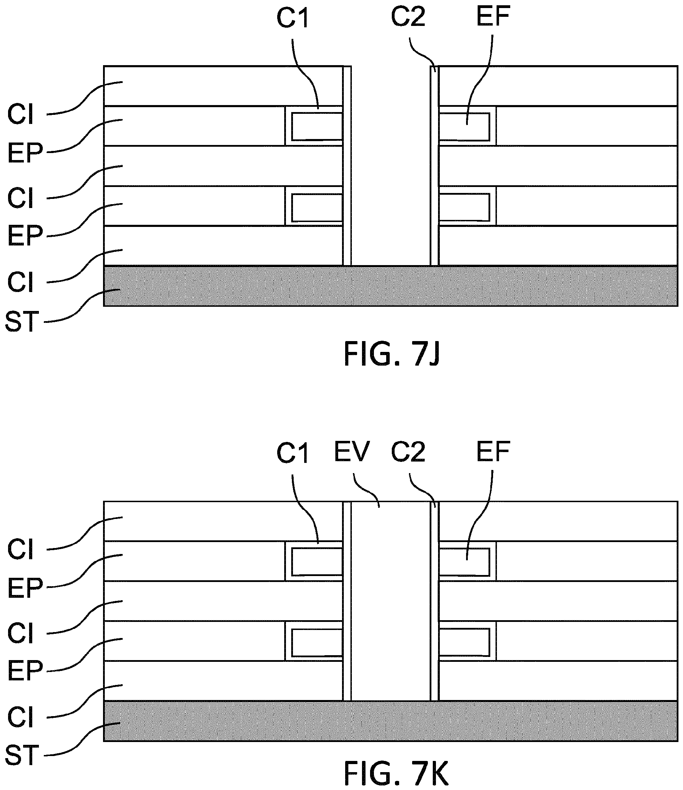

Comme illustré aux figures 7J, 8J et 9E, le procédé PRO comprend également une sixième étape D6 de dépôt conforme d'une deuxième couche C2 d'un deuxième matériau actif. Lorsque le deuxième matériau actif est destiné à jouer le rôle de sélecteur SE, ce dernier peut notamment être choisi parmi le VO$_x$, GeSe, TiO$_x$ et/ou TaxO$_y$. Lorsque ce deuxième matériau actif est destiné à jouer le rôle de point mémoire PM, ce dernier peut notamment être choisi parmi le HfO$_x$, Al$_x$O$_y$, Ta$_x$O$_y$, CuTeGe, GST, TiO$_x$ et/ou SiO$_x$. Lorsque le matériau conducteur déposé lors de la cinquième étape D5 de dépôt d'une couche EF' matériau conducteur est un métal de transition, alors le deuxième matériau actif de la deuxième couche C2 d'un matériau actif peut être obtenu par recuit (par traitement thermique ou par plasma) dans une atmosphère contrôlée. Par exemple, si le matériau conducteur déposé lors de la cinquième étape D5 de dépôt d'une couche EF' matériau conducteur est le hafnium, alors le deuxième matériau actif de la deuxième couche C2 d'un matériau actif est de l'hafnia (oxyde d'hafnium) obtenu par recuit (par traitement thermique ou par plasma) dans une atmosphère contrôlée riche en oxygène ou en ozone. Il apparait de manière évidente de ce qui précède que lorsque la première couche C1 d'un premier matériau actif est destinée à jouer le rôle de sélecteur SE (respectivement, de point mémoire PM) alors la deuxième couche C2 d'un deuxième matériau actif est destinée à jouer le rôle de point mémoire PM (respectivement, de sélecteur SE).

Enfin, comme illustré aux figures 7K, 8K et 9F, le procédé comprend en outre une septième étape D7 de dépôt d'une troisième couche EV d'un matériau conducteur. Le matériau déposé peut notamment être choisi parmi le TiN, TaN, TaCN, Ta, Ti, W, Cu, Al et Ag. La mémoire CO en 3D ainsi obtenue comprend une pluralité de premières électrodes EP, dite électrode plane EP, chaque électrode plane EP de la pluralité d'électrodes planes EP définissant un plan P ; une deuxième électrode EV, dite électrode verticale EV, s'étendant essentiellement selon un axe Z perpendiculaire au plan PM défini par chaque électrode plane EP ; une pluralité de premières couches CI d'un matériau isolant, chaque électrode plane EP de la pluralité d'électrodes planes EP étant séparée de l'électrode plane EP précédente et/ou suivante par une première couche CI d'un matériau isolant de la pluralité de premières couches CI d'un matériau isolant. La mémoire en 3D comprend également une pluralité de troisièmes électrodes EF, dite électrode flottante, chaque électrode flottante EF étant située entre l'électrode plane EP à laquelle elle est associée et l'électrode verticale EV ; une pluralité de premières couches C1 d'un premier matériau actif séparant chaque électrode plane EP de l'électrode flottante EF qui lui est associée ; une deuxième couche d'un deuxième matériau actif séparant l'électrode verticale EV de chaque électrode flottante EF de la pluralité d'électrodes flottantes EF. En outre, le premier matériau actif est apte à former un sélecteur SE ou un point mémoire PM et le deuxième matériau actif est apte à former un point mémoire PM ou un sélecteur SE.

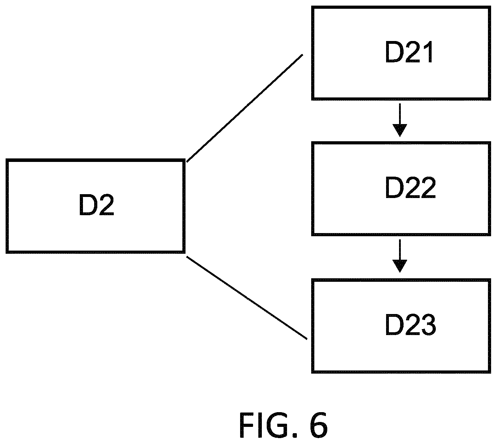

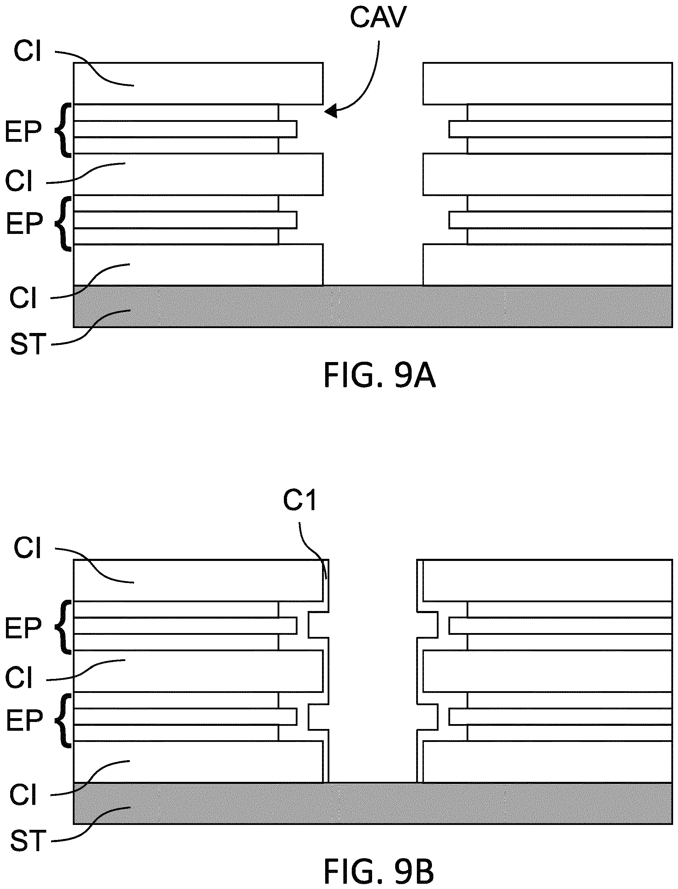

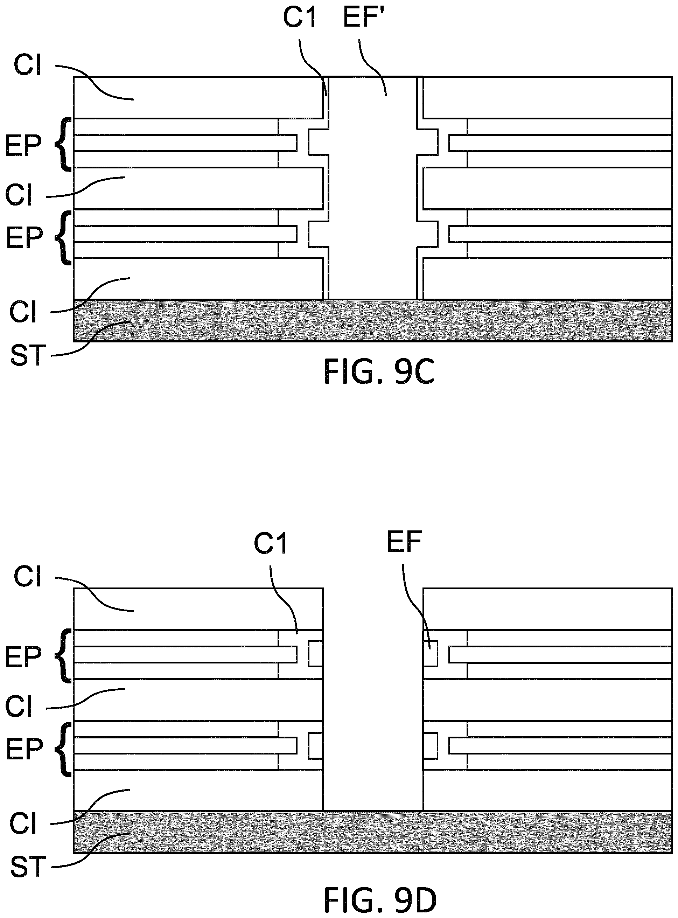

Dans un mode de réalisation illustré aux figures 6 et 8B, la deuxième étape D2 de dépôt d'une première couche EP d'un matériau conducteur sur la première couche CI d'un matériau isolant comprend une étape de dépôt d'une première sous-couche D21 dans un premier matériau conducteur de sous-couche ; une étape de dépôt d'une deuxième sous-couche D22 dans un deuxième matériau conducteur de sous-couche ; et une étape de dépôt d'une troisième sous-couche D23 dans un troisième matériau conducteur de sous-couche. De plus, comme illustré aux figures 8F et 9A, le premier matériau de la première sous-couche EP1 et le troisième matériau de la troisième sous-couche EP3 sont gravés à une vitesse différente de cette à laquelle est gravé le matériau de la deuxième sous-couche EP2 lors de la première étape SG1 de gravure sélective de la couche EP d'un matériau conducteur. De préférence, les matériaux conducteurs de la première sous-couche EP1 et de la troisième sous-couche EP3 sont identiques.

Dans un mode de réalisation illustré à la figure 8F, le premier matériau de la première sous-couche EP1 et le troisième matériau de la troisième sous-couche EP3 sont gravés à une vitesse inférieure à la vitesse à laquelle est gravé le deuxième matériau de la deuxième sous-couche EP2 lors de la première étape SG1 de gravure sélective de la pluralité de premières couches EP d'un matériau conducteur. Ainsi, comme illustré en à la figure 8K, à l'issue du procédé selon l'invention, l'extrémité proximale de la première sous-couche EP1 et l'extrémité proximale de la troisième sous-couche EP3 sont plus proches de l'électrode verticale EV que l'extrémité proximale de la deuxième sous-couche EP2 de sorte à former un retrait RET, une partie de l'électrode flottante s'insérant dans ledit retrait RET. Plus particulièrement, dans l'exemple de la figure 8K, l'électrode flottante EF prend la forme d'un T couché de sorte que la partie de l'électrode flottante EF correspondant au pied de la forme en T s'insère dans le retrait RET.

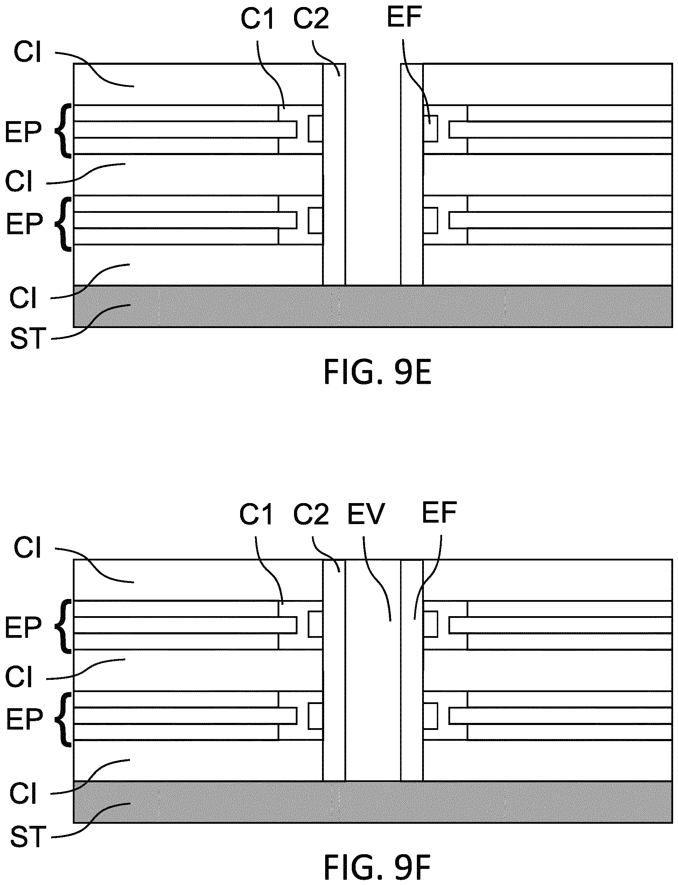

Dans un mode de réalisation alternatif illustré à la figure 9A, le premier matériau de la première sous-couche EP1 et le troisième matériau de la troisième sous-couche EP3 sont gravés à une vitesse supérieure à la vitesse à laquelle est gravé le deuxième matériau de la deuxième sous-couche EP2 lors de la première étape SG1 de gravure sélective de la pluralité de premières couches EP d'un matériau conducteur. Ainsi, comme illustré à la figure 9E, à l'issue du procédé selon l'invention, l'extrémité proximale de la première sous-couche EP1 et l'extrémité proximale de la troisième sous-couche EP3 sont plus éloignées de l'électrode verticale EV que l'extrémité proximale de la deuxième sous-couche EP2 de sorte à former une protubérance PRT, le premier matériau actif adoptant alors la forme d'un H couché. Préférentiellement, l'épaisseur de l'électrode flottante EF est supérieure à l'épaisseur de la deuxième sous-couche EP2 de l'électrode plane EP. Ainsi, comme illustré à la figure 9F, à l'issue du procédé on obtient une électrode plane EP dont l'extrémité est affinée ce qui permet favoriser réchauffement de ladite extrémité, et donc présente un avantage lorsque le point mémoire PM est un point mémoire à changement de phase.

Dans un exemple de réalisation, le procédé PRO comprend une première étape D1 de dépôt d'une première couche CI de SiOx, ladite couche ayant une épaisseur de 20 nm. Cette étape est suivie d'une deuxième étape D2 de dépôt d'une première couche EP de TiN, ladite couche ayant une épaisseur de 20nm et étant déposée sur la première couche CI de SiOx. Ces deux premières étapes sont répétées de sorte à obtenir une pluralité d'électrodes planes EP en TiN, chaque électrode plane EP étant séparée de la précédente et de la suivante par une couche CI de SiOx. Dans cet exemple de réalisation, le procédé PRO comprend également une troisième étape D3 de dépôt d'une deuxième couche CI de SiOx, ladite couche ayant également une épaisseur de 20 nm. Le procédé comprend ensuite une première étape AG1 de gravure anisotrope dans la pluralité de premières couches CI de SiOx, dans la deuxième couche CI de SiOx et dans la pluralité de premières couches EP de TiN. La ou les ouvertures (selon que le dispositif comporte une ou plusieurs électrodes verticales EV) sont de forme cylindrique et présentent une largeur de 100 nm (la hauteur de la ou des électrodes verticales EV étant fixée par le nombre d'électrodes planes EP). Cette étape est suivie d'une première étape SG1 de gravure sélective de la pluralité de premières couches EP de TiN de sorte à obtenir une cavité CAV ayant une profondeur de 20 nm. Le procédé comprend ensuite une quatrième étape D4 de dépôt conforme d'une couche C1 de HfO2, ladite couche ayant une épaisseur de 5nm et constituant la première couche d'un matériau actif C1. Cette étape est suivi d'une cinquième étape D5 de dépôt d'une couche EF' de Ti/TiN (5nm/10nm). Le procédé PRO comprend ensuite une deuxième étape AG2 de gravure anisotrope de la couche EF de Ti/TiN et de la couche C1 de HfO2. Le procédé comprend également une sixième étape D6 de dépôt conforme d'une deuxième couche C2 de GeSe, ladite couche ayant une épaisseur de 50nm. Enfin, le procédé comprend une septième étape D7 de dépôt d'une troisième couche EV de TiN de sorte à combler la ou les ouvertures. Ainsi, à chaque intersection électrode plane EP électrode verticale EV, la structure TiN/HfO2/Ti/TiN/GeSe/TiN est obtenue, ladite structure correspondant à une ReRAM (dans cet exemple donc, la mémoire est une mémoire résistive), une électrode flottante de TiN ainsi qu'un sélecteur. En inversant l'ordre de dépôt des deux matériaux actifs, il est évidemment possible d'obtenir la structure inverse.

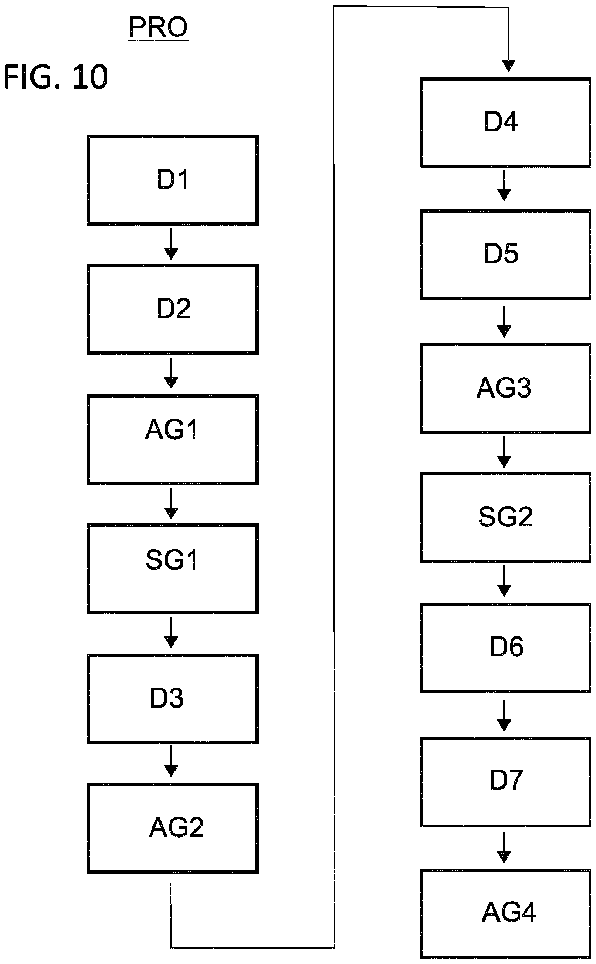

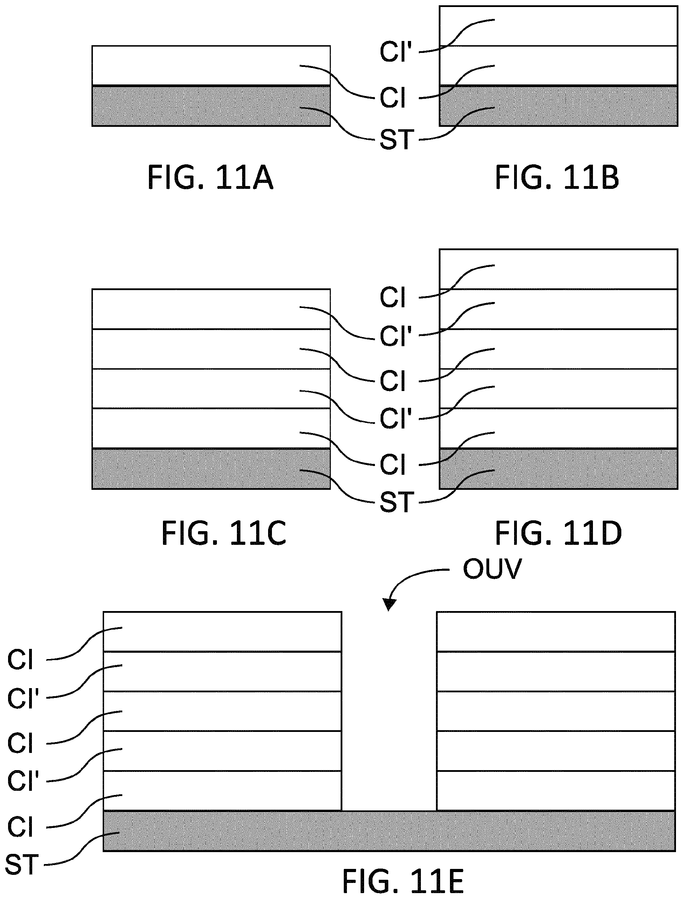

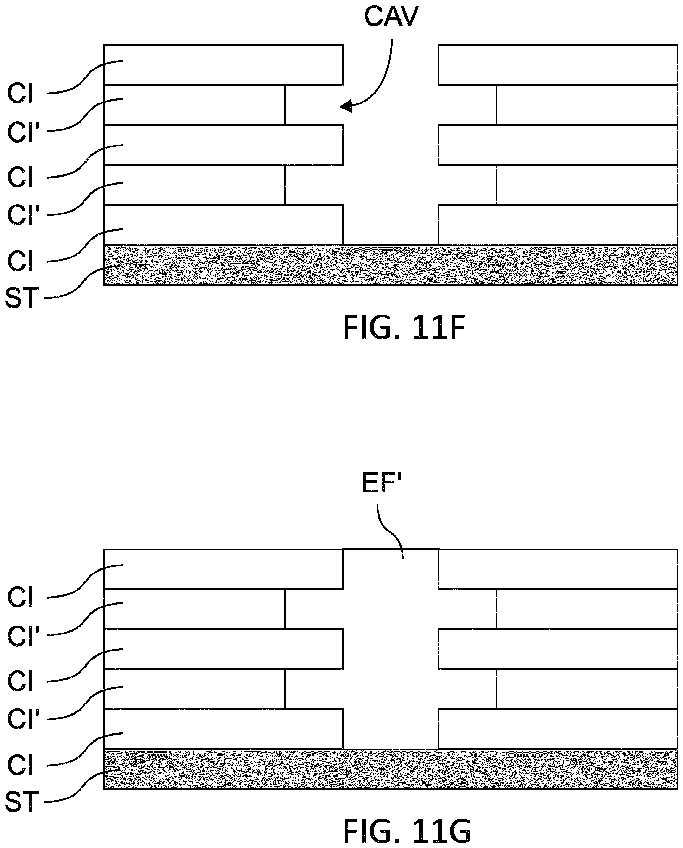

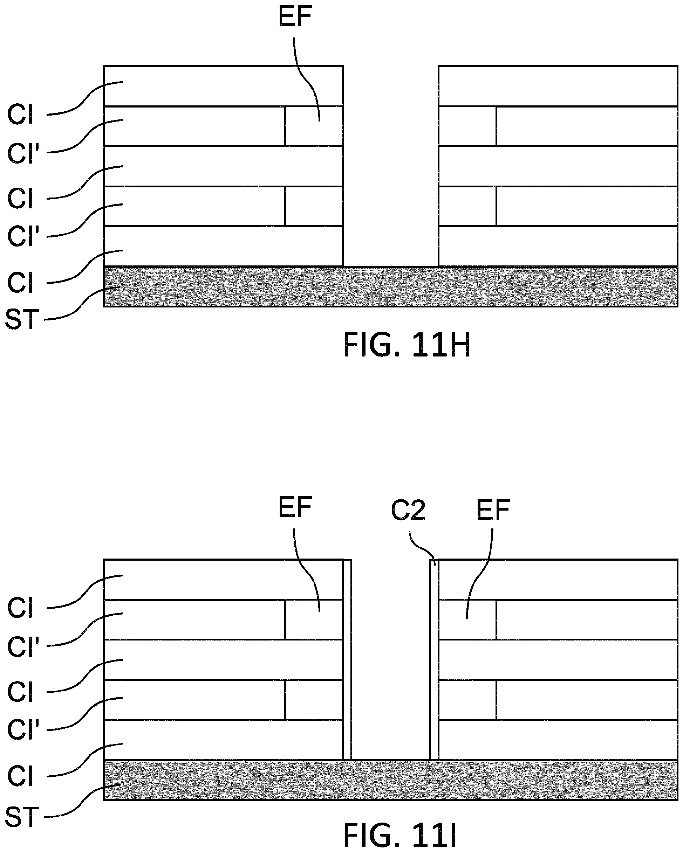

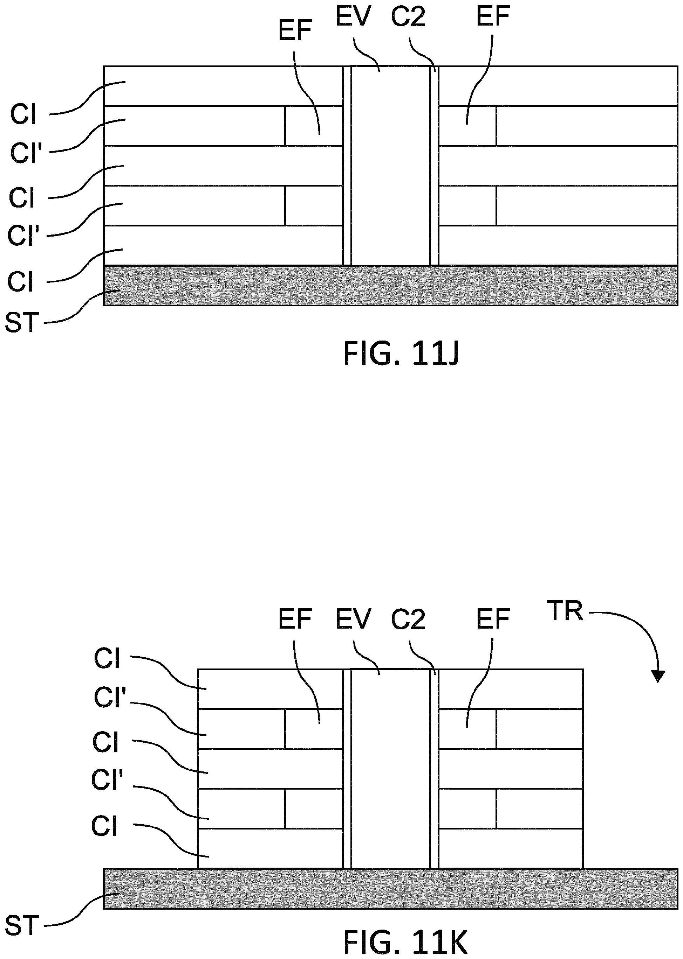

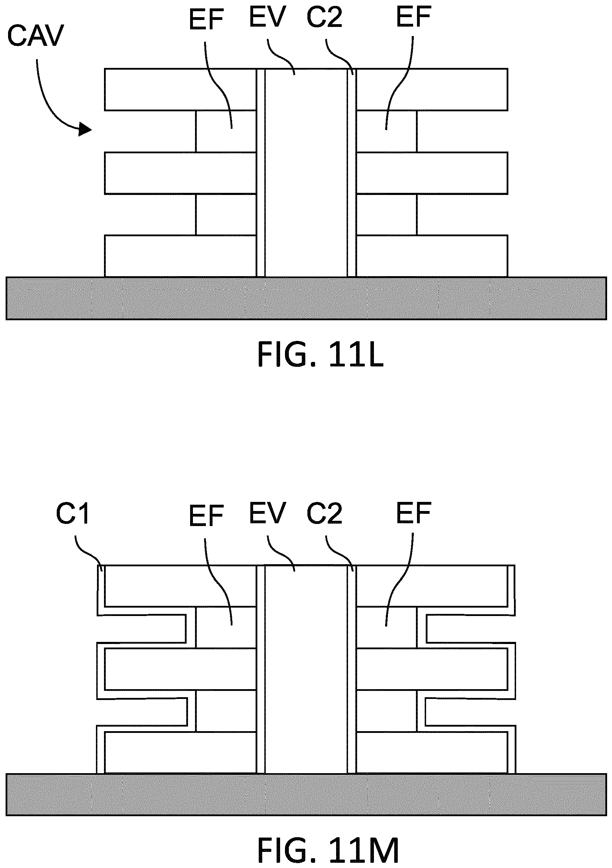

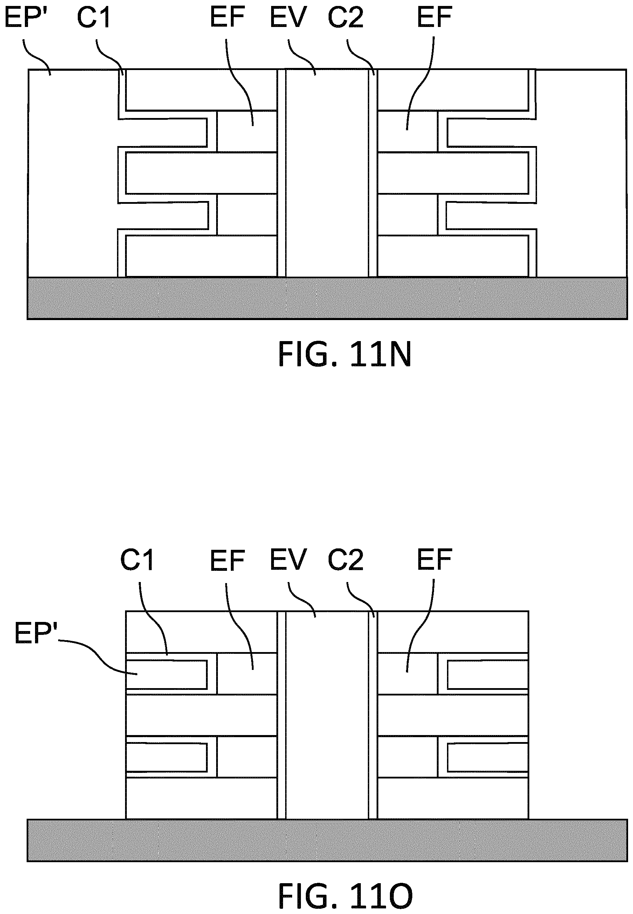

Afin d'obtenir une telle mémoire CO, un troisième aspect de l'invention illustré aux figures 10 et 11 concerne un procédé PRO de fabrication d'une mémoire en 3D. Comme illustré aux figures 11A à 11C, le procédé PRO de fabrication d'une mémoire en 3D selon un troisième aspect de l'invention comprend :

- une première étape D1 de dépôt d'une première couche CI d'un premier matériau isolant ;
- une deuxième étape D2 de dépôt d'une deuxième couche CI' d'un deuxième matériau isolant sur la première couche CI d'un premier matériau isolant ;

la première étape de dépôt D1 d'une première couche CI d'un premier matériau isolant et la deuxième étape D2 de dépôt d'une deuxième couche CI' d'un deuxième matériau isolant étant répétées, par exemple un nombre N de fois pour obtenir N points mémoire PM par électrode verticale EV, de sorte à obtenir une pluralité de premières couches CI d'un premier matériau isolant et une pluralité de deuxièmes couches CI' d'un deuxième matériau isolant. Le dépôt peut par exemple être effectué sur un substrat ST semi-conducteur, par exemple un substrat de silicium. Les premier et deuxième matériaux isolants peuvent être notamment choisis parmi le SiN et SiO$_x$. Bien entendu, le premier matériau isolant est différent du deuxième matériau isolant afin de pouvoir effectuer une gravure sélective comme nous le verrons dans la suite. Comme illustré aux figures 11D, le procédé PRO selon l'invention peut avantageusement comprendre une étape supplémentaire de dépôt d'une troisième couche CI d'un troisième matériau isolant sur la dernière deuxième couche CI' d'un deuxième matériau isolant de la pluralité de deuxièmes couches CI' d'un deuxième matériau isolant. Le matériau isolant peut-être notamment choisi parmi le SiN et SiO$_x$ et peut être identique au premier matériau isolant.

Comme illustré à la figure 11E, le procédé comprend également une première étape AG1 de gravure anisotrope dans la pluralité de premières couches CI d'un premier matériau isolant, dans la troisième couche CI d'un troisième matériau isolant (si cette dernière existe) et dans la pluralité de deuxièmes couches CI' d'un deuxième matériau isolant de sorte à créer une première ouverture OUV. Si nécessaire, cette gravure peut être effectuée en plusieurs sous-étapes, en fonction des matériaux utilisés pour les couches de matériaux isolants CI, CI'.

Comme illustré à la figure 11F, cette étape est suivie d'une première étape SG1 de gravure sélective de la pluralité de deuxièmes couches CI' d'un deuxième matériau isolant. La gravure étant sélective, la pluralité de premières couches CI d'un premier matériau isolant est gravée moins vite que la pluralité de deuxième couche CI' d'un deuxième matériau isolant de sorte qu'une cavité CAV est formée au niveau de chaque deuxième couche CI' d'un deuxième matériau isolant.

Comme illustrés à la figure 11G, cette étape est suivie d'une troisième étape D3 de dépôt d'une première couche EF' d'un matériau conducteur. Le matériau conducteur peut être choisi parmi le TiN, TaN, TaCN, Ta, Ti, W, Cu, Al et/ou Ag. Le matériau ainsi déposé remplit les cavités CAV obtenue lors de la première étape SG1 de gravure sélective. Sur la figure 11G, la première couche EF' d'un matériau conducteur est représentée comme remplissant la totalité de l'ouverture, mais il ne s'agit pas d'une obligation, la première couche EF' d'un matériau conducteur devant en revanche remplir la totalité de chaque cavité CAV.

Comme illustré à la figure 11H, cette étape est suivie d'une deuxième étape AG2 de gravure anisotrope de la première couche EF' d'un matériau conducteur. La gravure anisotrope permet de conserver la partie de la première couche EF' d'un matériau conducteur présente dans chaque cavité CAV de sorte à former, pour chaque future électrode plane EP une électrode flottante EF.

Comme illustré à la figure 11I, le procédé comprend ensuite une quatrième étape D4 de dépôt conforme d'une deuxième couche C2 d'un deuxième matériau actif. Lorsque le deuxième matériau actif est destiné à jouer le rôle de sélecteur, ce dernier peut notamment être choisi parmi le VO$_x$, GeSe, TiO$_x$ et/ou Ta$_x$O$_y$. Lorsque ce deuxième matériau actif est destiné à jouer le rôle de point mémoire, ce dernier peut notamment être choisi parmi le HfO$_x$, Al$_x$O$_y$, Ta$_x$O$_y$, CuTeGe, GST, TiO$_x$ et/ou SiO$_x$. Lorsque le matériau conducteur déposé lors de la troisième étape D3 de dépôt d'une première couche EF' d'un matériau conducteur est un métal de transition, alors le deuxième matériau actif de la deuxième couche C2 peut être déposé par recuit (par traitement thermique ou par plasma) dans une atmosphère contrôlée.

Comme illustré à la figure 11J, le procédé comprend ensuite une cinquième étape D5 de dépôt d'une deuxième couche EV d'un matériau conducteur. Le matériau déposé peut notamment être choisi parmi le TiN, TaN, TaCN, Ta, Ti, W, Cu, Al et Ag. Le matériau ainsi déposé permet de former l'électrode verticale EV de la mémoire en 3D.

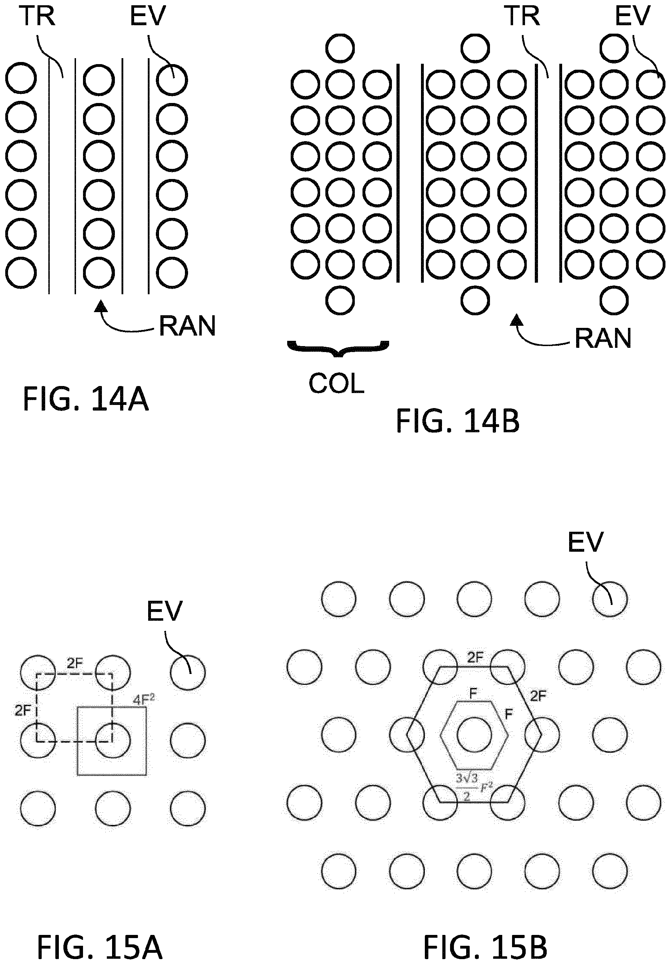

Comme illustré à la figure 11K, le procédé comprend également une troisième étape AG3 de gravure anisotrope dans la pluralité de premières couches CI d'un premier matériau isolant et dans la pluralité de deuxièmes couches CI' d'un deuxième matériau isolant, de sorte à obtenir une deuxième ouverture prenant la forme d'une tranchée. Si nécessaire, cette gravure peut être effectuée en plusieurs sous-étapes, en fonction des matériaux utilisés pour les couches de matériaux isolants. Lorsque plusieurs électrode verticales EV sont présentes, ces dernières sont en général organisées en une ou plusieurs rangés RAN. Dans ce cas, dans un premier mode de réalisation illustré à la figure 14A, chaque tranchée TR réalisée lors de la troisième étape AG3 de gravure anisotrope dans la pluralité de premières couches CI d'un premier matériau isolant et dans la pluralité de deuxièmes couches CI' d'un deuxième matériau isolant est disposé de sorte à séparées deux rangés RAN consécutives. Dans une mode de réalisation illustré à la figure 14B, les rangés RAN formes de colonnes COL, chaque colonnes COL comprenant plusieurs rangés RAN, et chaque tranchée TR réalisée lors de la troisième étape AG3 de gravure anisotrope dans la pluralité de premières couches CI d'un premier matériau isolant et dans la pluralité de deuxièmes couches CI' d'un deuxième matériau isolant est disposé de sorte à séparées deux colonnes COL consécutives.

Comme illustré à la figure 11L, le procédé comprend ensuite une deuxième étape SG2 de gravure sélective de la pluralité de deuxièmes couches CI' d'un deuxième matériau isolant. Comme cela a été détaillée pour la première étape de gravure sélective SG1, la pluralité de premières couches CI d'un premier matériau isolant est gravée moins vite que la pluralité de deuxièmes couches CI' d'un deuxième matériau isolant de sorte qu'une cavité CAV est formée au niveau de chaque deuxième couche CI' d'un deuxième matériau isolant. Comme illustré à la figure 4L, cette étape de gravure est effectuée jusqu'à ce que chaque électrode flottante EF soit dégagée, c'est-à-dire qu'une surface de chaque électrode flottante EF puisse être exposée à un dépôt de matériau.

Comme illustré à la figure 11M, le procédé comprend ensuite une sixième étape D6 de dépôt conforme d'une première couche C1 d'un premier matériau actif. Lorsque le premier matériau actif est destiné à jouer le rôle de sélecteur SE, ce dernier peut notamment être choisi parmi le $VO_x$, GeSe, $TiO_x$ et/ou $Ta_xO_y$. Lorsque ce premier matériau actif est destiné à jouer le rôle de point mémoire PM, ce dernier peut notamment être choisi parmi le $HfO_x$, $Al_xO_y$, $Ta_xO_y$, CuTeGe, GST, $TiO_x$ et/ou $SiO_x$. Il apparait de manière évidente de ce qui précède que lorsque la première couche C1 d'un premier matériau actif est destinée à jouer le rôle de sélecteur SE (respectivement, de point mémoire PM) alors la deuxième couche C2 d'un deuxième matériau actif est destinée à jour le rôle de point mémoire PM (respectivement, de sélecteur SE).

Comme illustré à la figure 11N, le procédé comprend ensuite une septième étape D7 de dépôt d'une troisième couche EP' d'un matériau conducteur. Le matériau conducteur peut être choisi parmi le TiN, TaN, TaCN, Ta, Ti, W, Cu, Al et/ou Ag. Le matériau est déposé de sorte à remplir les cavités CAV obtenue lors de la deuxième étape SG2 de gravure sélective.

Enfin, comme illustré à la figure 11O, le procédé comprend une quatrième étape AG4 de gravure anisotrope de la troisième couche EP' d'un matériau conducteur et de la première couche C1 d'un premier matériau actif. La reprise de contact au niveau de chaque électrode plane EP de la pluralité d'électrodes planes EP ainsi obtenu peut ensuite être réalisée, au niveau des tranchés TR par des procédés connus.

La mémoire CO en 3D ainsi obtenue comprend une pluralité de premières électrodes EP, dite électrode plane EP, chaque électrode plane EP de la pluralité d'électrodes planes EP définissant un plan P ; une deuxième électrode EV, dite électrode verticale EV, s'étendant essentiellement selon un axe Z perpendiculaire au plan PM défini par chaque électrode plane EP ; une pluralité de premières couches CI d'un matériau isolant, chaque électrode plane EP de la pluralité d'électrodes planes EP étant séparée de l'électrode plane EP précédente et/ou suivante par une première couche CI d'un matériau isolant de la pluralité de premières couches CI d'un matériau isolant. La mémoire en 3D comprend également une pluralité de troisièmes électrodes EF, dite électrode flottante, chaque électrode flottante EF étant située entre l'électrode plane EP à laquelle elle est associée et l'électrode verticale EV ; une pluralité de premières couches C1 d'un premier matériau actif séparant chaque électrode plane EP de l'électrode flottante EF qui lui est associée ; une deuxième couche d'un deuxième matériau actif séparant l'électrode verticale EV de chaque électrode flottante EF de la pluralité d'électrodes flottantes EF. En outre, le premier matériau actif est apte à former un sélecteur SE ou un point mémoire PM et le deuxième matériau actif est apte à former un point mémoire PM ou un sélecteur SE.

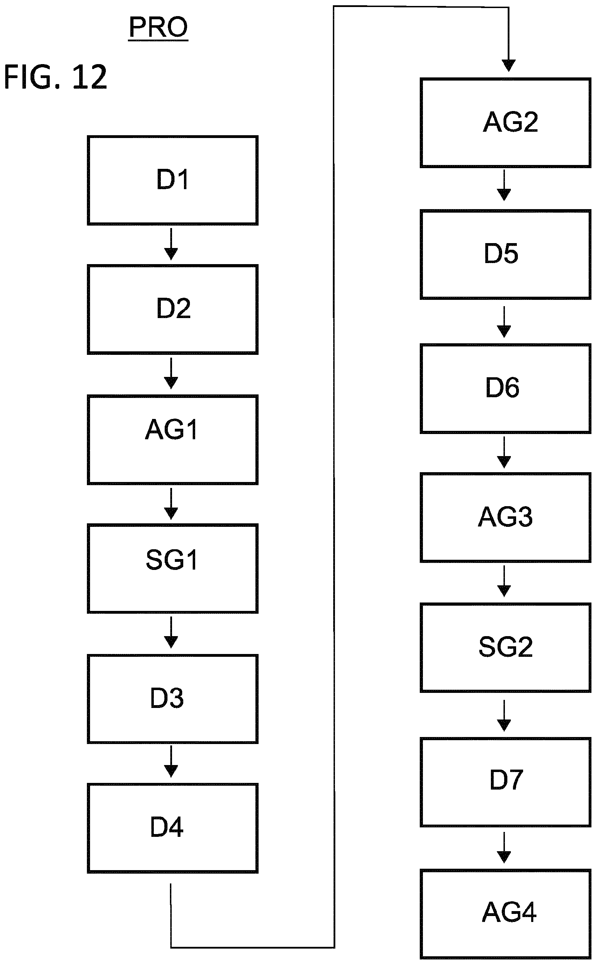

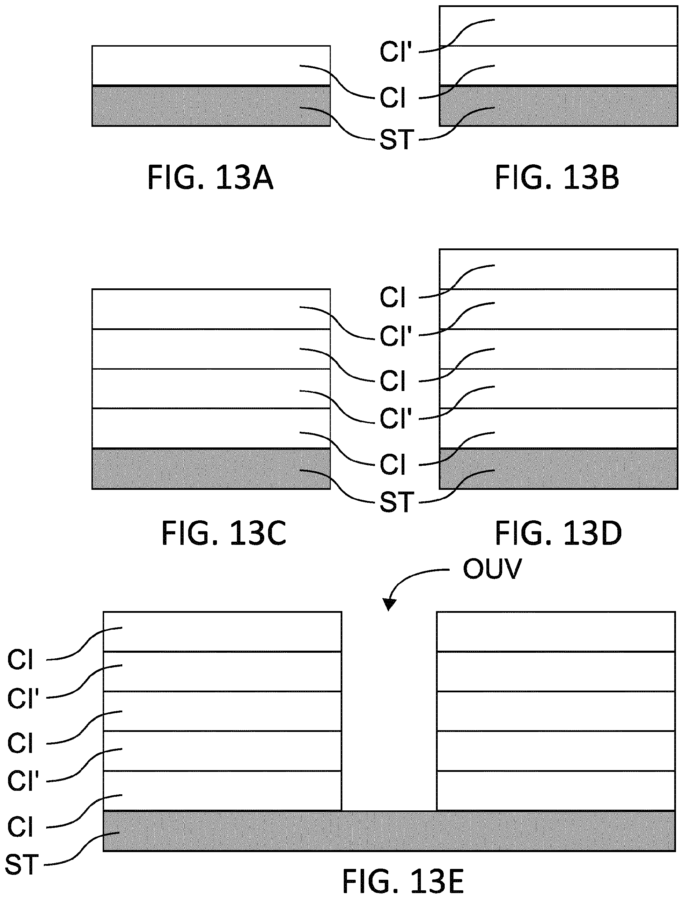

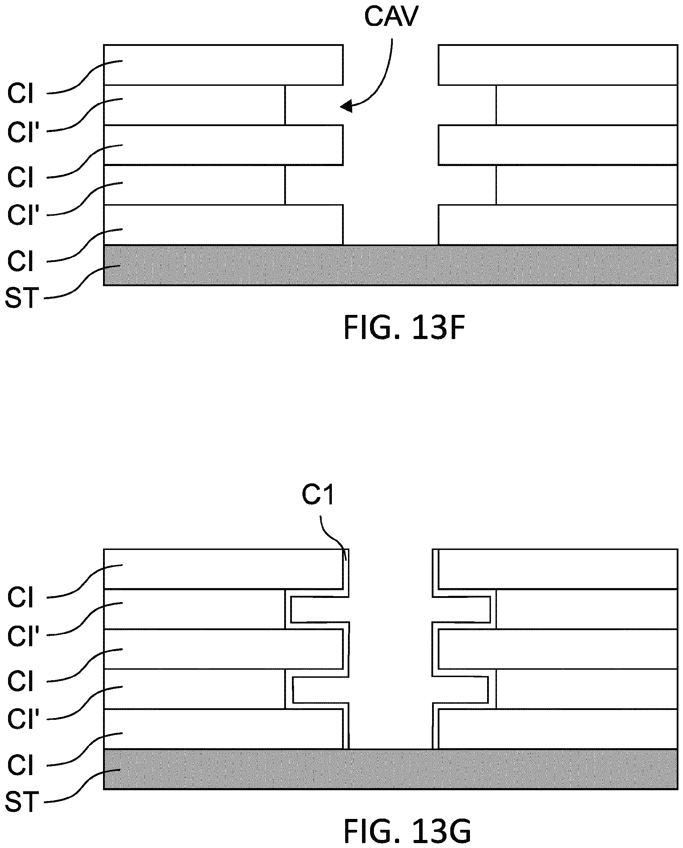

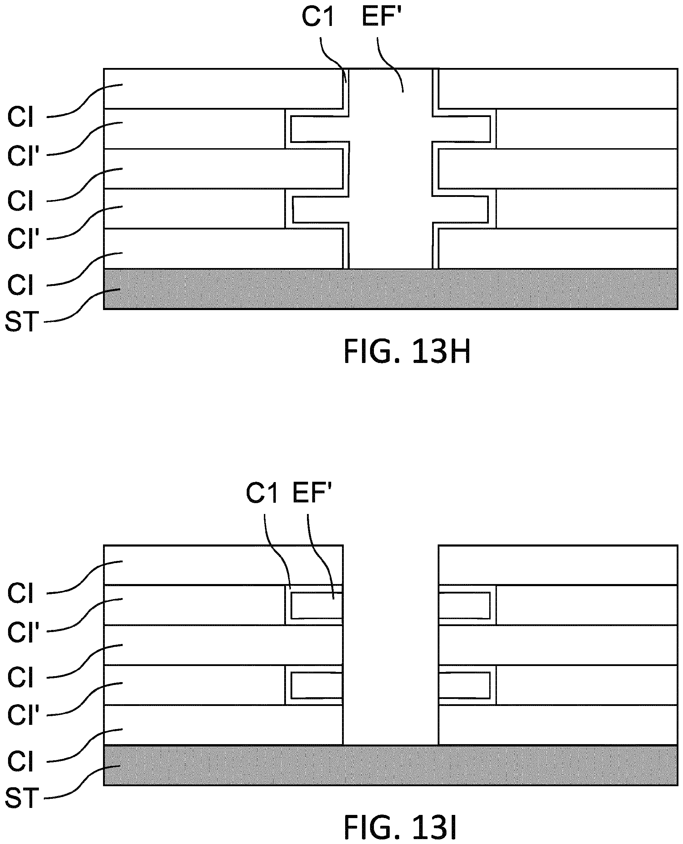

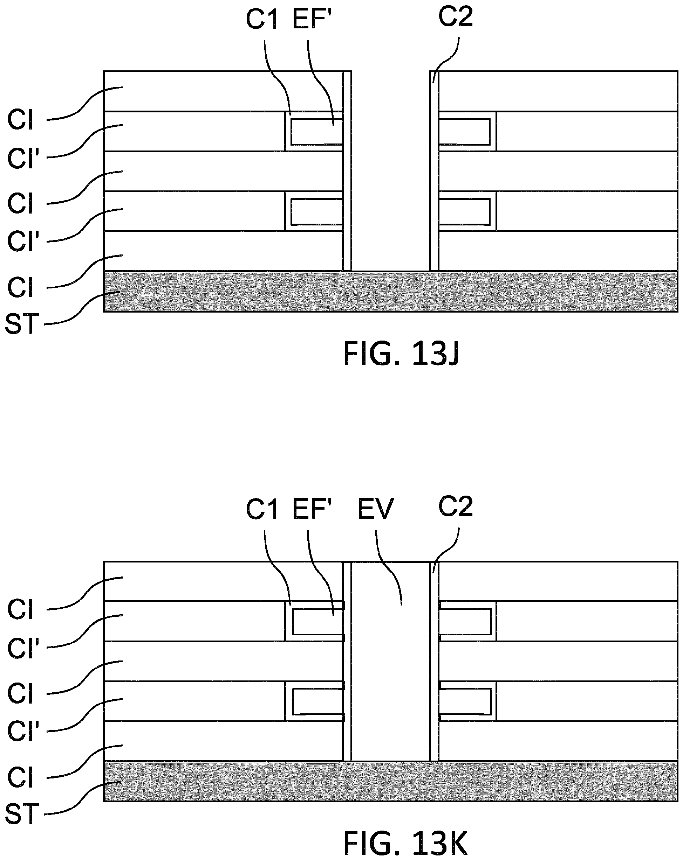

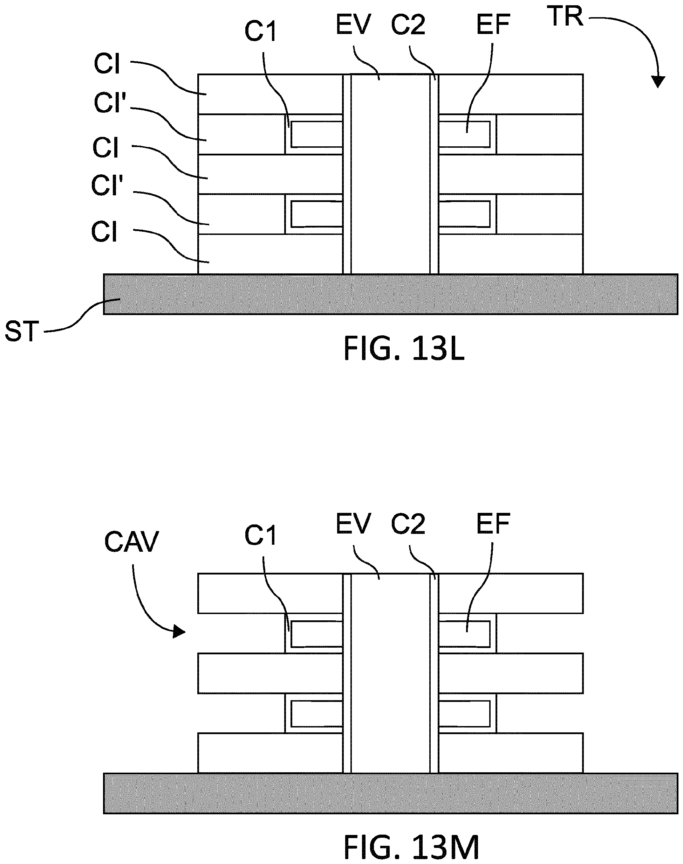

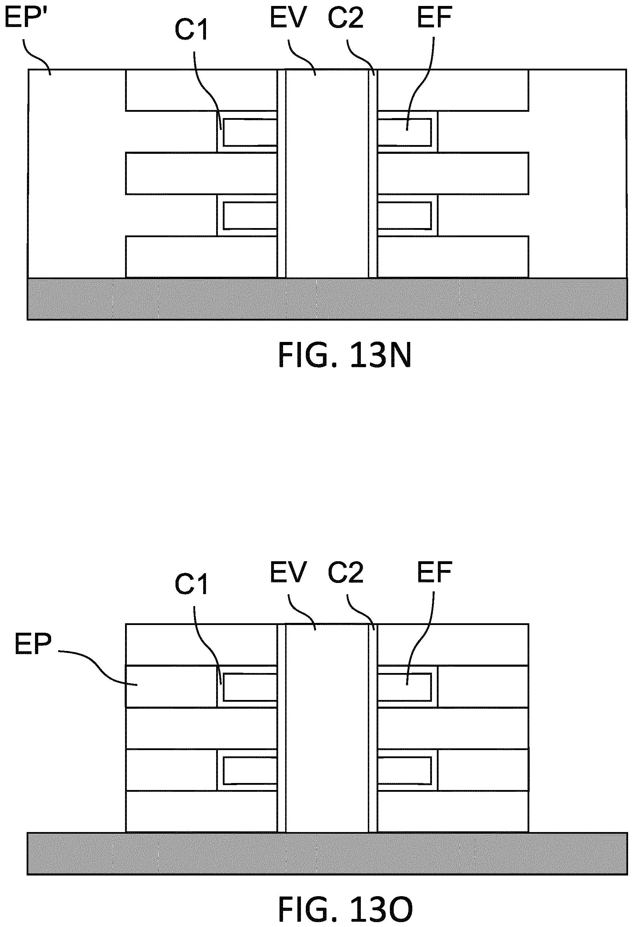

Un quatrième aspect illustré aux figures 12 et 13 concerne un procédé PRO de fabrication alternatif d'une mémoire en 3D. Comme illustré aux figures 13A à 13C, le procédé de fabrication d'une mémoire en 3D selon un deuxième aspect de l'invention comprend :

- une première étape D1 de dépôt d'une première couche CI d'un premier matériau isolant ;
- une deuxième étape D2 de dépôt d'une deuxième couche CI' d'un deuxième matériau isolant sur la première couche CI d'un premier matériau isolant.

Le dépôt peut par exemple être effectué sur un substrat ST semi-conducteur, par exemple un substrat de silicium. Les premier et deuxième matériaux isolants peuvent être notamment choisi parmi le SiN et SiO$_x$. Le premier matériau isolant est différent du deuxième matériau isolant de sorte à pouvoir être gravé de manière sélective comme nous le verrons dans la suite. La première étape D1 de dépôt d'une première couche CI d'un premier matériau isolant et la deuxième étape D2 de dépôt d'une deuxième couche EP d'un deuxième matériau isolant sont répétées, par exemple un nombre N de fois pour obtenir N points mémoire PM par électrode verticale EV, de sorte à obtenir une pluralité de première couche CI d'un premier matériau isolant et une pluralité de deuxièmes couches CI' d'un deuxième matériau conducteur. Comme illustré à la figure 13D, le procédé PRO selon l'invention peut avantageusement comprendre une étape supplémentaire de dépôt d'une troisième couche CI d'un troisième matériau isolant sur la dernière deuxième couche CI' d'un deuxième matériau isolant de la pluralité de deuxièmes couches CI' d'un deuxième matériau isolant. Le matériau isolant peut être notamment choisi parmi le SiN et SiO$_x$. Il peut être identique au premier matériau isolant.

Comme illustré à la figure 13E, le procédé comprend également une première étape AG1 de gravure anisotrope dans la pluralité de premières couches CI d'un premier matériau isolant, dans la troisième couche CI d'un troisième matériau isolant (si cette dernière existe) et dans la pluralité de deuxièmes couches CI' d'un deuxième matériau isolant de sorte à créer une première ouverture OUV. Si nécessaire, cette gravure peut être effectuée en plusieurs sous-étapes, en fonction des matériaux utilisés pour les couches de matériaux isolants.

Comme illustré à la figure 13F, le procédé comprend également une première étape SG1 de gravure sélective de la pluralité de deuxième couche CI' d'un deuxième matériau isolant. La gravure étant sélective, la pluralité de premières couches CI d'un premier matériau isolant est gravée moins vite que la pluralité de deuxièmes couches CI' d'un deuxième matériau isolant de sorte qu'une cavité CAV est formée au niveau de chaque deuxième couche CI' d'un deuxième matériau isolant.

Comme illustré à la figure 13G, le procédé comprend également une troisième étape D3 de dépôt conforme d'une première couche C1 d'un premier matériau actif. Lorsque le premier matériau actif est destiné à jouer le rôle de sélecteur SE, ce dernier peut notamment être choisi parmi le VO$_x$, GeSe, TiO$_x$ et/ou Ta$_x$O$_y$. Lorsque ce premier matériau actif est destiné à jouer le rôle de point mémoire PM, ce dernier peut notamment être choisi parmi le HfO$_x$, Al$_x$O$_y$, Ta$_x$O$_y$, CuTeGe, GST, TiO$_x$ et/ou SiO$_x$.

Comme illustré à la figure 13H, le procédé comprend ensuite une quatrième étape D4 de dépôt d'une première couche EF' d'un matériau conducteur. Le matériau conducteur peut être choisi parmi le TiN, TaN, TaCN, Ta, Ti, W, Cu, Al et/ou Ag. Le matériau ainsi déposé remplit les cavités CAV obtenue lors de la première étape SG1 de gravure sélective. Sur la figure 13H, la première couche EF' d'un matériau conducteur est représentée comme remplissant la totalité de l'ouverture, mais il ne s'agit pas d'une obligation, la première couche EF' d'un matériau conducteur devant en revanche remplir la totalité de chaque cavité CAV.

Comme illustré à la figure 13I, cette étape est suivie d'une deuxième étape AG2 de gravure anisotrope de la première couche EF' d'un matériau conducteur et dans la première couche C1 d'un premier matériau actif. La gravure anisotrope permet de conserver la partie de la deuxième couche EF' d'un matériau conducteur et la première couche d'un matériau actif C1 présentes dans la cavité CAV de sorte à former, pour chaque future électrode plane EP, une électrode flottante EF.

Comme illustré à la figure 13J, le procédé comprend également une cinquième étape D5 de dépôt conforme d'une deuxième couche C2 d'un deuxième matériau actif. Lorsque le deuxième matériau actif est destiné à jouer le rôle de sélecteur, ce dernier peut notamment être choisi parmi le VO$_x$, GeSe, TiO$_x$ et/ou Ta$_x$O$_y$. Lorsque ce deuxième matériau actif est destiné à jouer le rôle de point mémoire, ce dernier peut notamment être choisi parmi le HfO$_x$, Al$_x$O$_y$, Ta$_x$O$_y$, CuTeGe, GST, TiO$_x$ et/ou SiO$_x$. Lorsque le matériau conducteur déposé lors de la cinquième étape D5 de dépôt d'une première couche EF' matériau conducteur est un métal de transition, alors le deuxième matériau actif de la deuxième couche C2 d'un matériau actif peut être déposé par recuit (par traitement thermique ou par plasma) dans une atmosphère contrôlée. Il apparait de manière évidente de ce qui précède que lorsque la première couche C1 d'un premier matériau actif est destinée à jouer le rôle de sélecteur SE (respectivement, de point mémoire PM) alors la deuxième couche C2 d'un deuxième matériau actif est destinée à jouer le rôle de point mémoire PM (respectivement, de sélecteur SE).

Comme illustré à la figure 13K, le procédé comprend ensuite une sixième étape D6 de dépôt d'une deuxième couche EV d'un matériau conducteur. Le matériau déposé peut notamment être choisi parmi le TiN, TaN, TaCN, Ta, Ti, W, Cu, Al et Ag. Le matériau ainsi déposé permet de former l'électrode verticale EV de la mémoire en 3D.

Comme illustré à la figure 13L, le procédé comprend également une troisième étape AG3 de gravure anisotrope dans la pluralité de premières couches CI d'un premier matériau isolant et dans la pluralité de deuxièmes couches CI' d'un deuxième matériau isolant, de sorte à obtenir une deuxième ouverture prenant la forme d'une tranchée. Si nécessaire, cette gravure peut être effectuée en plusieurs sous-étapes, en fonction des matériaux utilisés pour les couches de matériaux isolants CI, CI'.

Lorsque plusieurs électrode verticales EV sont présentes, ces dernières sont en général organisées en une ou plusieurs rangés RAN. Dans ce cas, dans un premier mode de réalisation illustré à la figure 14A, chaque tranchée TR réalisée lors de la troisième étape AG3 de gravure anisotrope dans la pluralité de premières couches CI d'un premier matériau isolant et dans la pluralité de deuxièmes couches CI' d'un deuxième matériau isolant est disposé de sorte à séparées deux rangés RAN consécutives. Dans une mode de réalisation illustré à la figure 14B, les rangés RAN formes de colonnes COL, chaque colonnes COL comprenant plusieurs rangés RAN, et chaque tranchée TR réalisée lors de la troisième étape AG3 de gravure anisotrope dans la pluralité de premières couches CI d'un premier matériau isolant et dans la pluralité de deuxièmes couches CI' d'un deuxième matériau isolant est disposé de sorte à séparées deux colonnes COL consécutives.

Comme illustré à la figure 13M, le procédé comprend ensuite une deuxième étape SG2 de gravure sélective de la pluralité de deuxièmes couches CI' d'un deuxième matériau isolant. Comme cela a été détaillée pour la première étape de gravure sélective SG1, la pluralité de premières couches CI d'un premier matériau isolant est gravée moins vite que la pluralité de deuxièmes couches CI' d'un deuxième matériau isolant de sorte qu'une cavité CAV est formée au niveau de chaque deuxième couche CI' d'un deuxième matériau isolant. Comme illustré à la figure 6M, cette étape de gravure est effectuée jusqu'à ce que chaque première couche C1 d'un premier matériau actif soit dégagée, c'est-à-dire qu'une surface de chaque première couche C1 d'un premier matériau actif puisse être exposée à un dépôt de matériau.

Comme illustré à la figure 13N, le procédé comprend également une septième étape D7 de dépôt d'une troisième couche EP' d'un matériau conducteur. Le matériau conducteur peut être choisi parmi le TiN, TaN, TaCN, Ta, Ti, W, Cu, Al et/ou Ag. Le matériau est déposé de sorte à remplir les cavités CAV obtenue lors de la deuxième étape SG2 de gravure sélective. Enfin, comme illustré à la figure 13O, le procédé comprend une quatrième étape AG4 de gravure anisotrope de la quatrième couche EP' d'un matériau conducteur. La reprise de contact au niveau de chaque électrode plane EP de la pluralité d'électrodes planes EP ainsi obtenu peut ensuite être réalisée, au niveau des tranchés TR par des procédés connus.

La mémoire CO en 3D obtenue à l'aide d'un procédé selon un deuxième aspect, un troisième aspect ou un quatrième aspect de l'invention comprend donc une pluralité de premières électrodes EP, dite électrode plane EP, chaque électrode plane EP de la pluralité d'électrodes planes EP définissant un plan P ; une deuxième électrode EV, dite électrode verticale EV, s'étendant essentiellement selon un axe Z perpendiculaire au plan PM défini par chaque électrode plane EP ;

une pluralité de premières couches CI d'un matériau isolant, chaque électrode plane EP de la pluralité d'électrodes des planes EP étant séparée de l'électrode plane EP précédente et/ou suivante par une première couche CI d'un matériau isolant de la pluralité de premières couches CI d'un matériau isolant. La mémoire en 3D comprend également une pluralité de troisièmes électrodes EF, dite électrode flottante, chaque électrode flottante EF étant située entre l'électrode plane EP à laquelle elle est associée et l'électrode verticale EV ; une pluralité de premières couches C1 d'un premier matériau actif séparant chaque électrode plane EP de l'électrode flottante EF qui lui est associée ; une deuxième couche d'un deuxième matériau actif séparant l'électrode verticale EV de chaque électrode flottante EF de la pluralité d'électrodes flottantes EF. En outre, le premier matériau actif est apte à former un sélecteur SE ou un point mémoire PM et le deuxième matériau actif est apte à former un point mémoire PM ou un sélecteur SE.

Bien entendu, dans les modes de réalisation présentés ci-dessus, une mémoire CO en 3D comportant une seule électrode verticale EV a été considérée pour des raisons de clarté. Cependant, le procédé de fabrication s'applique de manière identique pour la fabrication d'une mémoire CO en 3D comprenant une pluralité d'électrodes verticales EV. La seule modification concerne la première étape AG1 de gravure anisotrope durant laquelle non pas une, mais une pluralité d'ouvertures OUV devra être réalisée de sorte à obtenir une pluralité d'électrodes verticales EV. Lorsqu'une mémoire CO en 3D selon l'invention comprend une pluralité d'électrodes verticales EV, il est possible de faire varier la disposition des électrodes verticales EV les unes par rapport aux autres. La figure 15A illustre une première disposition dans laquelle la projection de la pluralité d'électrodes verticales EV sur un plan parallèle aux plans P formés par les électrodes planes EP forme un réseau dont la maille élémentaire est une maille carrée. La figure 15B illustre quant à elle une deuxième disposition dans laquelle la projection de la pluralité d'électrodes verticales EV sur un plan parallèle aux plans P formés par les électrodes planes EP forme un réseau dont la maille élémentaire est une maille losange. La structure de la figure 15B propose une densité d'électrodes verticales EV (et donc de points mémoire PM) plus importante que la structure de la figure 15A. D'autres mailles élémentaires peuvent bien entendu être envisagées.

## Revendications

1. Mémoire (CO) en trois dimensions comprenant :

   - pluralité de premières électrodes (EP), dite électrode plane (EP), chaque électrode plane (EP) de la pluralité d'électrodes planes (EP) définissant un plan (P) ;
   - une deuxième électrode (EV), dite électrode verticale (EV), s'étendant essentiellement selon un axe (Z) perpendiculaire au plan défini par chaque électrode plane (EP) ;

- une pluralité de troisième électrode (EF), dite électrode flottante, chaque électrode flottante (EF) de la pluralité d'électrodes flottantes (EF) étant située entre une électrode plane (EP) de la pluralité d'électrodes planes (EP) et l'électrode verticale (EV) ;

- une pluralité de premières couches (CI) d'un matériau isolant, chaque électrode plane (EP) de la pluralité d'électrodes planes (EP) étant séparés de l'électrode plane (EP) précédente et/ou suivante par une première couche (CI) d'un matériau isolant de la pluralité de premières couches (CI) d'un matériau isolant

- une pluralité de première couche (C1) d'un premier matériau actif, chaque couche (C1) d'un matériau actif séparant une électrode plane (EP) de la pluralité d'électrodes planes (EP) de l'électrode flottante (EF) qui lui est associée ;

- une deuxième couche d'un deuxième matériau actif (C2) séparant l'électrode verticale (EV) des électrodes flottantes (EF) de la pluralité d'électrodes flottantes (EF) ; le premier matériau actif étant apte à former un sélecteur (SE) ou un point mémoire (PM) et le deuxième matériau actif étant apte à former un point mémoire (PM) ou un sélecteur (SE), la mémoire étant **caractérisée en ce que** chaque l'électrode plane (EP) de la pluralité d'électrodes planes (EP) comprend :

- une première sous-couche (EP1) dans un premier matériau conducteur ;

- une deuxième sous-couche (EP2) dans un deuxième matériau conducteur ; et

- une troisième sous-couche (EP3) dans un troisième matériau conducteur.

2. Mémoire selon la revendication précédente **caractérisé en ce que** l'extrémité proximale de la première sous-couche (EP1) et l'extrémité proximale de la troisième sous-couche (EP3) sont plus proches de l'électrode verticale (EV) que l'extrémité proximale de la deuxième sous-couche (EP2) de sorte à former un retrait (RET), une partie de l'électrode flottante (EF) s'insérant dans ledit retrait (RET).

3. Mémoire selon la revendication 2 **caractérisé en ce que** l'extrémité proximale de la première sous-couche (EP1) et l'extrémité proximale de la troisième sous-couche (EP3) sont plus éloignées de l'électrode verticale (EV) que l'extrémité proximale de la deuxième sous-couche (EP2) de sorte à former une protubérance (PROT).

4. Mémoire selon la revendication 3 **caractérisé en ce que** l'épaisseur de l'électrode flottante (EF) associée à l'électrode plane (EP) considérée est supérieure à l'épaisseur de la deuxième sous-couche (EP2) de l'électrode plane (EP).

5. Procédé de fabrication d'une mémoire en 3D comprenant :

- une première étape (D1) de dépôt d'une première couche (CI) d'un matériau isolant ;

- une deuxième étape (D2) de dépôt d'une première couche (EP) d'un matériau conducteur sur la première couche (CI) d'un matériau isolant ;

la première étape de dépôt (D1) d'une première couche (CI) d'un matériau isolant et la deuxième étape (D2) de dépôt d'une première couche (EP) d'un matériau conducteur étant répétées de sorte à obtenir une pluralité de premières couches (CI) d'un matériau isolant et une pluralité de premières couches (EP) d'un matériau conducteur, le procédé comprenant également :

- une première étape (AG1) de gravure anisotrope dans la pluralité de premières couches (CI) d'un matériau isolant et dans la pluralité de premières couches (EP) d'un matériau conducteur ;

- une première étape (SG1) de gravure sélective de la pluralité de première couche (EP) d'un matériau conducteur ;

- une quatrième étape (D4) de dépôt conforme d'une première couche (C1) d'un premier matériau actif ;

- une cinquième étape (D5) de dépôt d'une deuxième couche (EF') d'un matériau conducteur ;

- une deuxième étape (AG2) de gravure anisotrope de la couche (EF') d'un matériau conducteur et de la couche (C1) d'un premier matériau actif ;

- une sixième étape (D6) de dépôt conforme d'une deuxième couche (C2) d'un deuxième matériau actif ;

- une septième étape (D7) de dépôt d'une troisième couche (EV) d'un matériau conducteur ;

le procédé étant **caractérisé en ce que** la deuxième étape (D2) de dépôt d'une première couche (EP) d'un matériau conducteur sur la première couche (CI) d'un matériau isolant comprend :

- une étape (D21) de dépôt d'une première sous-couche (EP1) dans un premier matériau conducteur;

- une étape (D22) de dépôt d'une deuxième sous-couche (EP2) dans un deuxième matériau conducteur;

- une étape (D23) de dépôt d'une troisième sous-couche (EP3) dans un troisième matériau conducteur ;

le matériau de la première sous-couche (EP1) et le matériau de la troisième sous-couche (EP3) étant gravés à une vitesse différente de celle à laquelle est gravé le matériau de la deuxième sous-couche (EP2) lors de la première étape (SG1) de gravure sélective de la pluralité de premières couches (EP) d'un matériau conducteur.

6. Procédé selon la revendication précédente dans lequel le premier matériau de la première sous-couche (EP1) et le troisième matériau de la troisième sous-couche (EP3) sont gravés à une vitesse inférieure à la vitesse à laquelle est gravé le deuxième matériau de la deuxième sous-couche (EP2) lors de la première étape (SG1) de gravure sélective de la pluralité de premières couches (EP) d'un matériau conducteur.

7. Procédé selon la revendication 5 dans lequel le premier matériau de la première sous-couche (EP1) et le troisième matériau de la troisième sous-couche (EP3) sont gravés à une vitesse supérieure à la vitesse à laquelle est gravé le deuxième matériau de la deuxième sous-couche (EP2) lors de la première étape (SG1) de gravure sélective de la pluralité de premières couches (EP) d'un matériau conducteur.

8. Procédé de fabrication d'une mémoire en 3D comprenant :

   - une première étape (D1) de dépôt d'une première couche (CI) d'un premier matériau isolant ;
   - une deuxième étape (D2) de dépôt d'une deuxième couche (CI') d'un deuxième matériau isolant sur la première couche (CI) d'un premier matériau isolant ;

   la première étape de dépôt (D1) d'une première couche (CI) d'un premier matériau isolant et la deuxième étape (D2) de dépôt d'une deuxième couche (CI') d'un deuxième matériau isolant étant répétées de sorte à obtenir une pluralité de premières couches (CI') d'un premier matériau isolant et une pluralité de deuxième couches (CI') d'un deuxième matériau isolant, le procédé comprenant également :

   - une première étape (AG1) de gravure anisotrope dans la pluralité de premières couches (CI) d'un premier matériau isolant et dans la pluralité de deuxièmes couches (CI') d'un deuxième matériau isolant de sorte à créer une première ouverture ;
   - une première étape (SG1) de gravure sélective de la pluralité de deuxièmes couches (CI') d'un deuxième matériau isolant ;
   - une troisième étape (D3) de dépôt d'une première couche (EF') d'un matériau conducteur ;
   - une deuxième étape (AG2) de gravure anisotrope de la première couche (EF') d'un matériau conducteur ;
   - une quatrième étape (D4) de dépôt conforme d'une deuxième couche (C2) d'un deuxième matériau actif ;
   - une cinquième étape (D5) de dépôt d'une deuxième couche (EV) d'un matériau conducteur ;
   - une troisième étape (AG3) de gravure anisotrope dans la pluralité de premières couches (CI) d'un premier matériau isolant et dans la pluralité de deuxièmes couches (CI') d'un deuxième matériau isolant, de sorte à obtenir une deuxième ouverture prenant la forme d'une tranchée ;
   - une deuxième étape (SG2) de gravure sélective de la pluralité de deuxièmes couches (CI') d'un deuxième matériau isolant ;
   - une sixième étape (D6) de dépôt conforme d'une première couche (C1) d'un premier matériau actif ;
   - une septième étape (D7) de dépôt d'une troisième couche (EP') d'un matériau conducteur;

   la troisième couche (EP') comprend:- une première sous-couche (EP1) dans un premier matériau conducteur;

   - une deuxième sous-couche (EP2) dans un deuxième matériau conducteur; et
   - une troisième sous-couche (EP3) dans un troisième matériau conducteur,
   - une quatrième étape (AG4) de gravure anisotrope de la troisième couche (EP') d'un matériau conducteur et de la première couche (C1) d'un premier matériau actif.

9. Procédé de fabrication d'une mémoire en 3D comprenant :

   - une première étape (D1) de dépôt d'une première couche (CI) d'un premier matériau isolant ;
   - une deuxième étape (D2) de dépôt d'une deuxième couche (C1') d'un deuxième matériau isolant sur la première couche (CI) d'un premier matériau isolant ;

   la première étape de dépôt (D1) d'une première couche (CI) d'un premier matériau isolant et la deuxième étape (D2) de dépôt d'une deuxième couche (CI') d'un deuxième matériau isolant étant répétées de sorte à obtenir une pluralité de premières couches (CI) d'un premier matériau isolant et une pluralité de deuxièmes couches (CI') d'un deuxième matériau isolant, le procédé comprenant également :

- une première étape (AG1) de gravure anisotrope dans la pluralité de premières couches (CI) d'un premier matériau isolant et dans la pluralité de deuxièmes couches (CI') d'un deuxième matériau isolant de sorte à créer une première ouverture ;
- une première étape (SG1) de gravure sélective de la pluralité de deuxièmes couches (CI') d'un deuxième matériau isolant ;
- une troisième étape (D3) de dépôt conforme d'une première couche (C1) d'un premier matériau actif ;
- une quatrième étape (D4) de dépôt d'une première couche (EF') d'un matériau conducteur ;
- une deuxième étape (AG2) de gravure anisotrope de la première couche (EF') d'un matériau conducteur et de la première couche (C1) d'un premier matériau actif ;
- une cinquième étape (D5) de dépôt conforme d'une deuxième couche (C2) d'un deuxième matériau actif ;
- une sixième étape (D6) de dépôt d'une deuxième couche (EV) d'un matériau conducteur ;
- une troisième étape (AG3) de gravure anisotrope dans la pluralité de premières couches (CI) d'un premier matériau isolant et dans la pluralité de deuxièmes couches (CI') d'un deuxième matériau isolant, de sorte à obtenir une deuxième ouverture prenant la forme d'une tranchée ;
- une deuxième étape (SG2) de gravure sélective de la pluralité de deuxièmes couches (CI') d'un deuxième matériau isolant ;
- une septième étape (D7) de dépôt d'une troisième couche (EP') d'un matériau conducteur;

la troisième couche (EP') comprend:

- une première sous-couche (EP1) dans un premier matériau conducteur;
- une deuxième sous-couche (EP2) dans un deuxième matériau conducteur; et
- une troisième sous-couche (EP3) dans un troisième matériau conducteur,
- une quatrième étape (AG4) de gravure anisotrope de la troisième couche (EP') d'un matériau conducteur.

**Patentansprüche**

1. Speicher (CO) in drei Dimensionen, umfassend:

- eine Vielzahl von ersten Elektroden (EP), bezeichnet als ebene Elektrode (EP), wobei jede ebene Elektrode (EP) der Vielzahl von ebenen Elektroden (EP) eine Ebene (P) definiert;

- eine zweite Elektrode (EV), bezeichnet als vertikale Elektrode (EV), die sich im Wesentlichen entlang einer Achse (Z) erstreckt, die vertikal zu der von jeder ebenen Elektrode (EP) definierten Ebene ist;
- eine Vielzahl von dritten Elektroden (EF), bezeichnet als schwebende Elektroden, wobei jede schwebende Elektrode (EF) der Vielzahl von schwebenden Elektroden (EF) zwischen einer ebenen Elektrode (EP) der Vielzahl von ebenen Elektroden (EP) und der vertikalen Elektrode (EV) angeordnet ist;
- eine Vielzahl von ersten Schichten (CI) eines isolierenden Materials, wobei jede ebene Elektrode (EP) der Vielzahl von ebenen Elektroden (EP) von der ebenen Elektrode (EP) vor und/oder nach einer ersten Schicht (CI) eines isolierenden Materials der Vielzahl von ersten Schichten (CI) eines isolierenden Materials getrennt ist;
- eine Vielzahl von ersten Schichten (C1) eines ersten aktiven Materials, wobei jede Schicht (C1) eines aktiven Materials eine ebene Elektrode (EP) von der Vielzahl von ebenen Elektroden (EP) der schwebenden Elektrode (EF), die ihr zugeordnet ist, trennt;
- eine zweite Schicht eines aktiven Materials (C2), das die vertikale Elektrode (EV) der schwebenden Elektroden (EF) von der Vielzahl von schwebenden Elektroden (EF) trennt;

wobei das erste aktive Material geeignet ist, einen Wähler (SE) oder einen Speicherpunkt (PM) zu bilden und das zweite aktive Material geeignet ist, einen Speicherpunkt (PM) oder einen Wähler (SE) zu bilden, wobei der Speicher **dadurch gekennzeichnet ist, dass** jede ebene Elektrode (EP) der Vielzahl von ebenen Elektroden (EP) umfasst:

- eine erste Teilschicht (EP1) aus einem ersten leitenden Material;
- eine zweite Teilschicht (EP2) aus einem zweiten leitenden Material; und
- eine dritte Teilschicht (EP3) aus einem dritten leitenden Material.

2. Speicher gemäß dem voranstehenden Anspruch, **dadurch gekennzeichnet, dass** das proximale Ende der ersten Teilschicht (EP1) und das proximale Ende der dritten Teilschicht (EP3) näher an der vertikalen Elektrode (EV) sind als das proximale Ende der zweiten Teilschicht (EP2) derart, dass eine Ausnehmung (RET) gebildet ist, wobei sich ein Teil der schwebenden Elektrode (EF) in die genannte Ausnehmung (RET) einfügt.

3. Speicher gemäß Anspruch 2, **dadurch gekennzeichnet, dass** das proximale Ende der ersten Teilschicht (EP1) und das proximale Ende der dritten Teilschicht (EP3) weiter von der vertikalen Elektrode (EV) entfernt sind als das proximale Ende der zweiten Teilschicht (EP2) derart, dass eine Protuberanz (PROT) gebildet ist.

4. Speicher gemäß Anspruch 3, **dadurch gekennzeichnet, dass** die Dicke der schwebenden Elektrode (EF) der betrachteten ebenen Elektrode (EP) zugeordnet ist, die stärker ist als die Dicke der zweiten Teilschicht (EP2) der ebenen Elektrode (P).

5. Herstellungsverfahren eines 3D-Speichers, umfassend:

   - einen ersten Aufbringungsschritt (D1) einer ersten Schicht (CI) eines isolierenden Materials;
   - einen zweiten Aufbringungsschritt (D2) einer ersten Schicht (EP) eines leitenden Materials auf der ersten Schicht (CI) eines isolierenden Materials;

   wobei der erste Aufbringungsschritt (D1) einer ersten Schicht (CI) eines isolierenden Materials und der zweite Aufbringungsschritt (D2) einer ersten Schicht (EP) eines leitenden Materials derart wiederholt werden, dass eine Vielzahl von ersten Schichten (CI) eines isolierenden Materials und eine Vielzahl von ersten Schichten (EP) eines leitenden Materials erhalten werden, wobei das Verfahren ebenfalls umfasst:

   - einen ersten anisotropen Ätzschritt (AG1) in der Vielzahl von ersten Schichten (CI) eines isolierenden Materials und in der Vielzahl von ersten Schichten (EP) eines leitenden Materials;
   - einen ersten selektiven anisotropen Ätzschritt (SG1) der Vielzahl von ersten Schichten (EP) eines leitenden Materials;
   - einen vierten konformen Aufbringungsschritt (D4) einer ersten Schicht (C1) eines ersten aktiven Materials;
   - einen fünften Aufbringungsschritt (D5) einer zweiten Schicht (EF') eines leitenden Materials;
   - einen zweiten anisotropen Ätzschritt (AG2) der Schicht (EF') eines leitenden Materials und der Schicht (C1) eines ersten aktiven Materials;
   - einen sechsten konformen Aufbringungsschritt (D6) einer zweiten Schicht (C2) eines zweiten aktiven Materials;
   - einen siebten Aufbringungsschritt (D7) einer dritten Schicht (EV) eines leitenden Materials;

   wobei das Verfahren **dadurch gekennzeichnet ist, dass** der zweite Aufbringungsschritt (D2) einer ersten Schicht (EP) eines leitenden Materials auf der ersten Schicht (CI) eines isolierenden Materials umfasst:

   - einen Aufbringungsschritt (D21) einer ersten Teilschicht (EP1) aus einem ersten leitenden Material;
   - einen Aufbringungsschritt (D22) einer zweiten Teilschicht (EP2) aus einem zweiten leitenden Material;
   - einen Aufbringungsschritt (D23) einer dritten Teilschicht (EP3) aus einem dritten leitenden Material;

   wobei das Material der ersten Teilschicht (EP1) und das Material der dritten Teilschicht (EP3) in einer unterschiedlichen Geschwindigkeit zu der geätzt werden, in der das Material der zweiten Teilschicht (EP2) im ersten selektiven Ätzschritt (SG1) der Vielzahl von ersten Schichten (EP) eines leitenden Material geätzt wird.

6. Verfahren gemäß dem voranstehenden Anspruch, bei dem das erste Material der ersten Teilschicht (EP1) und das dritte Material der dritten Teilschicht (EP3) in einer geringeren Geschwindigkeit als der Geschwindigkeit geätzt werden, in der das zweite Material der zweiten Teilschicht (EP2) im ersten selektiven Ätzschritt (SG1) der Vielzahl von ersten Schichten (EP) eines leitenden Materials geätzt wird.

7. Verfahren gemäß Anspruch 5, bei dem das erste Material der ersten Teilschicht (EP1) und das dritte Material der dritten Teilschicht (EP3) in einer größeren Geschwindigkeit als der Geschwindigkeit geätzt werden, in der das zweite Material der zweiten Teilschicht (EP2) im ersten selektiven Ätzschritt (SG1) der Vielzahl von ersten Schichten (EP) eines leitenden Materials geätzt wird.

8. Herstellungsverfahren eines 3D-Speichers, umfassend:

   - einen ersten Aufbringungsschritt (D1) einer ersten Schicht (CI) eines ersten isolierenden Materials;
   - einen zweiten Aufbringungsschritt (D2) einer zweiten Schicht (CI') eines zweiten isolierenden Materials auf der ersten Schicht (CI) eines ersten isolierenden Materials;

   wobei der erste Aufbringungsschritt (D1) einer ersten Schicht (CI) eines ersten isolierenden Materials und der zweite Aufbringungsschritt (D2) einer zweiten Schicht (CI') eines zweiten isolierenden Materials derart wiederholt werden, dass eine Vielzahl von ersten Schichten (CI') eines ersten isolierenden Materials und eine Vielzahl von zweiten Schichten (CI') eines zweiten isolierenden Materials erhalten werden; wobei das Verfahren ebenfalls umfasst:

- einen ersten anisotropen Ätzschritt (AG1) in der Vielzahl von ersten Schichten (CI) eines ersten isolierenden Materials und in der Vielzahl von zweiten Schichten (CI') eines zweiten isolierenden Materials derart, dass eine erste Öffnung hergestellt wird;
- einen ersten selektiven Ätzschritt (SG1) der Vielzahl von zweiten Schichten (CI') eines zweiten isolierenden Materials;
- einen dritten Aufbringungsschritt (D3) einer ersten Schicht (EF') eines leitenden Materials;
- einen zweiten anisotropen Ätzschritt (AG2) der ersten Schicht (EF') eines leitenden Materials;
- einen vierten konformen Aufbringungsschritt (D4) einer zweiten Schicht (C2) eines zweiten aktiven Materials;
- einen fünften Aufbringungsschritt (D5) einer zweiten Schicht (EV) eines leitenden Materials;
- einen dritten anisotropen Ätzschritt (AG3) in der Vielzahl von ersten Schichten (CI) eines ersten isolierenden Materials und in der Vielzahl von zweiten Schichten (CI') eines zweiten isolierenden Materials derart, dass eine zweite Öffnung erhalten wird, die die Form eines Grabens annimmt;
- einen selektiven Ätzschritt (SG2) der Vielzahl von zweiten Schichten (CI') eines zweiten isolierenden Materials;
- einen sechsten konformen Aufbringungsschritt (D6) einer ersten Schicht (C1) eines ersten aktiven Materials;
- einen siebten Aufbringungsschritt (D7) einer dritten Schicht (EP') eines leitenden Materials; die dritte Schicht (EP') umfasst:

  ■ eine erste Teilschicht (EP1) aus einem ersten leitenden Material;
  ■ eine zweite Teilschicht (EP2) aus einem zweiten leitenden Material; und
  ■ eine dritte Teilschicht (EP3) aus einem dritten leitenden Material,

- einen vierten anisotropen Ätzschritt (AG4) der dritten Schicht (EP') eines leitenden Materials und der ersten Schicht (C1) eines ersten aktiven Materials.

9. Herstellungsverfahren eines 3D-Speichers, umfassend:

  - einen ersten Aufbringungsschritt (D1) einer ersten Schicht (CI) eines ersten isolierenden Materials;
  - einen zweiten Aufbringungsschritt (D2) einer zweiten Schicht (CI') eines zweiten isolierenden Materials auf der ersten Schicht (CI) eines ersten isolierenden Materials;

wobei der erste Aufbringungsschritt (D1) einer ersten Schicht (CI) eines ersten isolierenden Materials und der zweite Aufbringungsschritt (D2) einer zweiten Schicht (CI') eines zweiten isolierenden Materials derart wiederholt werden, dass eine Vielzahl von ersten Schichten (CI) eines ersten isolierenden Materials und eine Vielzahl von zweiten Schichten (CI') eines zweiten isolierenden Materials erhalten werden, wobei das Verfahren ebenfalls umfasst:

  - einen ersten anisotropen Ätzschritt (AG1) in der Vielzahl von ersten Schichten (CI) eines ersten isolierenden Materials und in der Vielzahl von zweiten Schichten (CI') eines zweiten isolierenden Materials derart, dass eine erste Öffnung hergestellt wird;
  - einen ersten selektiven Ätzschritt (SG1) der Vielzahl von zweiten Schichten (CI') eines zweiten isolierenden Materials;
  - einen dritten konformen Aufbringungsschritt (D3) einer ersten Schicht (C1) eines ersten aktiven Materials;
  - einen vierten Aufbringungsschritt (D4) einer ersten Schicht (EF') eines leitenden Materials;
  - einen zweiten anisotropen Ätzschritt (AG2) der ersten Schicht (EF') eines leitenden Materials und der ersten Schicht (C1) eines ersten aktiven Materials;
  - einen fünften konformen Aufbringungsschritt (D5) einer zweiten Schicht (C2) eines zweiten aktiven Materials;
  - einen sechsten Aufbringungsschritt (D6) einer zweiten Schicht (EV) eines leitenden Materials;
  - einen dritten anisotropen Ätzschritt (AG3) in der Vielzahl von ersten Schichten (CI) eines ersten isolierenden Materials und in der Vielzahl von zweiten Schichten (CI') eines zweiten isolierenden Materials derart, dass eine zweite Öffnung erhalten wird, die die Form eines Grabens annimmt;
  - einen zweiten selektiven Ätzschritt (SG2) der Vielzahl von zweiten Schichten (CI') eines zweiten isolierenden Materials;
  - einen siebten Aufbringungsschritt (D7) einer dritten Schicht (EP') eines leitenden Materials; wobei die dritte Schicht (EP') umfasst:

    ■ eine erste Teilschicht (EP1) aus einem ersten leitenden Material;
    ■ eine zweite Teilschicht (EP2) aus einem zweiten leitenden Material; und
    ■ eine dritte Teilschicht (EP3) aus einem dritten leitenden Material

  - einen vierten anisotropen Ätzschritt (AG4) der dritten Schicht (EP') eines leitenden Materials.

**Claims**

1. Three dimensional memory (CO) comprising:

     - a plurality of first electrodes (EP), referred to as flat electrodes (EP), each flat electrode (EP) of the plurality of flat electrodes (EP) defining a plane (P);
     - a second electrode (EV), referred to as vertical electrode (EV), extending essentially along an axis (Z) perpendicular to the plane defined by each flat electrode (EP);
     - a plurality of third electrodes (EF), referred to as floating electrodes, each floating electrode (EF) of the plurality of floating electrodes (EF) being situated between a flat electrode (EP) of the plurality of flat electrodes (EP) and the vertical electrode (EV);
     - a plurality of first layers (CI) of an insulating material, each flat electrode (EP) of the plurality of flat electrodes (EP) being separated from the preceding and/or following flat electrode (EP) by a first layer (CI) of an insulating material of the plurality of first layers (CI) of an insulating material;
     - a plurality of first layers (C1) of a first active material, each layer (C1) of an active material separating a flat electrode (EP) of the plurality of flat electrodes (EP) from the floating electrode (EF) that is associated therewith;
     - a second layer of a second active material (C2) separating the vertical electrode (EV) from the floating electrodes (EF) of the plurality of floating electrodes (EF);

   the first active material being capable of forming a selector (SE) or a memory point (PM) and the second active material being capable of forming a memory point (PM) or a selector (SE), the memory being **characterised in that** each flat electrode (EP) of the plurality of flat electrodes (EP) comprises:

     - a first sub-layer (EP1) made of a first conductive material;
     - a second sub-layer (EP2) made of a second conductive material; and
     - a third sub-layer (EP3) made of a third conductive material.

2. Memory according to the preceding claim **characterised in that** the proximal end of the first sub-layer (EP1) and the proximal end of the third sub-layer (EP3) are closer to the vertical electrode (EV) than the proximal end of the second sub-layer (EP2) so as to form an indentation (RET), a part of the floating electrode (EF) being inserted into said indentation (RET).

3. Memory according to claim 2 **characterised in that** the proximal end of the first sub-layer (EP1) and the proximal end of the third sub-layer (EP3) are further away from the vertical electrode (EV) than the proximal end of the second sub-layer (EP2) so as to form a protuberance (PROT).

4. Memory according to claim 3 **characterised in that** the thickness of the floating electrode (EF) associated with the considered flat electrode (EP) is greater than the thickness of the second sub-layer (EP2) of the flat electrode (EP).

5. Method for manufacturing a 3D memory comprising:

     - a first step (D1) of deposition of a first layer (CI) of an insulating material;
     - a second step (D2) of deposition of a first layer (EP) of a conductive material on the first layer (CI) of an insulating material;

   the first step of deposition (D1) of a first layer (CI) of an insulating material and the second step (D2) of deposition of a first layer (EP) of a conductive material being repeated so as to obtain a plurality of first layers (CI) of an insulating material and a plurality of first layers (EP) of a conductive material, the method also comprising:

     - a first step (AG1) of anisotropic etching in the plurality of first layers (CI) of an insulating material and in the plurality of first layers (EP) of a conductive material;
     - a first step (SG1) of selective etching of the plurality of first layers (EP) of a conductive material;
     - a fourth step (D4) of conformal deposition of a first layer (C1) of a first active material;
     - a fifth step (D5) of deposition of a second layer (EF') of a conductive material;
     - a second step (AG2) of anisotropic etching of the layer (EF') of a conductive material and the layer (C1) of a first active material;
     - a sixth step (D6) of conformal deposition of a second layer (C2) of a second active material;
     - a seventh step (D7) of deposition of a third layer (EV) of a conductive material;

   the method being **characterised in that** the second step (D2) of deposition of a first layer (EP) of a conductive material on the first layer (CI) of an insulating material comprises:

     - a step (D21) of deposition of a first sub-layer (EP1) made of a first conductive material;
     - a step (D22) of deposition of a second sub-layer (EP2) made of a second conductive material;

- a step (D23) of deposition of a third sub-layer (EP3) made of a third conductive material;

the material of the first sub-layer (EP1) and the material of the third sub-layer (EP3) being etched at a rate different to that at which the material of the second sub-layer (EP2) is etched during the first step (SG1) of selective etching of the plurality of first layers (EP) of a conductive material.

6. Method according to the preceding claim wherein the first material of the first sub-layer (EP1) and the third material of the third sub-layer (EP3) are etched at a rate slower than the rate at which the second material of the second sub-layer (EP2) is etched during the first step (SG1) of selective etching of the plurality of first layers (EP) of a conductive material.

7. Method according to claim 5 wherein the first material of the first sub-layer (EP1) and the third material of the third sub-layer (EP3) are etched at a rate faster than the rate at which the second material of the second sub-layer (EP2) is etched during the first step (SG1) of selective etching of the plurality of first layers (EP) of a conductive material.

8. Method for manufacturing a 3D memory comprising:

    - a first step (D1) of deposition of a first layer (CI) of a first insulating material;
    - a second step (D2) of deposition of a second layer (CI') of a second insulating material on the first layer (CI) of a first insulating material;

    the first step of deposition (D1) of a first layer (CI) of a first insulating material and the second step (D2) of deposition of a second layer (CI') of a second insulating material being repeated so as to obtain a plurality of first layers (CI') of a first insulating material and a plurality of second layers (CI') of a second insulating material, the method also comprising:

    - a first step (AG1) of anisotropic etching in the plurality of first layers (CI) of a first insulating material and in the plurality of second layers (CI') of a second insulating material so as to create a first opening;
    - a first step (SG1) of selective etching of the plurality of second layers (CI') of a second insulating material;
    - a third step (D3) of deposition of a first layer (EF') of a conductive material;
    - a second step (AG2) of anisotropic etching of the first layer (EF') of a conductive material;
    - a fourth step (D4) of conformal deposition of a second layer (C2) of a second active material;
    - a fifth step (D5) of deposition of a second layer (EV) of a conductive material;

- a third step (AG3) of anisotropic etching in the plurality of first layers (CI) of a first insulating material and in the plurality of second layers (CI') of a second insulating material, so as to obtain a second opening taking the form of a trench;
- a second step (SG2) of selective etching of the plurality of second layers (CI') of a second insulating material;
- a sixth step (D6) of conformal deposition of a first layer (C1) of a first active material;
- a seventh step (D7) of deposition of a third layer (EP') of a conductive material, the third layer (EP') comprising:

    ▪ a first sub-layer (EP1) made of a first conductive material;
    ▪ a second sub-layer (EP2) made of a second conductive material; and
    ▪ a third sub-layer (EP3) made of a third conductive material;

- a fourth step (AG4) of anisotropic etching of the third layer (EP') of a conductive material and the first layer (C1) of a first active material.

9. Method for manufacturing a 3D memory comprising:

    - a first step (D1) of deposition of a first layer (CI) of a first insulating material;
    - a second step (D2) of deposition of a second layer (CI') of a second insulating material on the first layer (CI) of a first insulating material;

    the first step of deposition (D1) of a first layer (CI) of a first insulating material and the second step (D2) of deposition of a second layer (CI') of a second insulating material being repeated so as to obtain a plurality of first layers (CI) of a first insulating material and a plurality of second layers (CI') of a second insulating material, the method also comprising:

    - a first step (AG1) of anisotropic etching in the plurality of first layers (CI) of a first insulating material and in the plurality of second layers (CI') of a second insulating material so as to create a first opening;
    - a first step (SG1) of selective etching of the plurality of second layers (CI') of a second insulating material;
    - a third step (D3) of conformal deposition of a first layer (C1) of a first active material;
    - a fourth step (D4) of deposition of a first layer (EF') of a conductive material;
    - a second step (AG2) of anisotropic etching of the first layer (EF') of a conductive material and the first layer (C1) of a first active material;
    - a fifth step (D5) of conformal deposition of a second layer (C2) of a second active material;

- a sixth step (D6) of deposition of a second layer (EV) of a conductive material;
- a third step (AG3) of anisotropic etching in the plurality of first layers (CI) of a first insulating material and in the plurality of second layers (CI') of a second insulating material, so as to obtain a second opening taking the form of a trench;
- a second step (SG2) of selective etching of the plurality of second layers (CI') of a second insulating material;
- a seventh step (D7) of deposition of a third layer (EP') of a conductive material, the third layer (EP') comprising:

   ▪ a first sub-layer (EP1) made of a first conductive material;
   ▪ a second sub-layer (EP2) made of a second conductive material; and
   ▪ a third sub-layer (EP3) made of a third conductive material;

- a fourth step (AG4) of anisotropic etching of the third layer (EP') of a conductive material.

FIG. 1A

FIG. 1B

FIG. 2

## FIG. 3A

## FIG. 3B

FIG. 4A

C2    EV

EP1

EP2

EP3

CI

P

C1    EF

PT

FIG. 4B

Z

PRO

FIG. 5

FIG. 6

EP — CI — ST

**FIG. 7A**

EP — CI — ST

**FIG. 7B**

CI — EP — CI — EP — CI — ST

**FIG. 7C**

CI — EP — CI — EP — CI — ST

**FIG. 7D**

OUV

CI — EP — CI — EP — CI — ST

**FIG. 7E**

CAV

CI

EP

CI

EP

CI

ST

## FIG. 7F

C1

CI

EP

CI

EP

CI

ST

## FIG. 7G

C1   EF'

CI

EP

CI

EP

CI

ST

FIG. 7H

C1                    EF

CI

EP

CI

EP

CI

ST

FIG. 7I

C1          C2      EF

CI

EP

CI

EP

CI

ST

FIG. 7J

C1   EV   C2      EF

CI

EP

CI

EP

CI

ST

FIG. 7K

FIG. 8A      FIG. 8B

FIG. 8C      FIG. 8D

FIG. 8E

CAV

CI

EP {

CI

EP {

CI

ST

FIG. 8F

C1

CI

EP {

CI

EP {

CI

ST

FIG. 8G

C1  EF'

CI

EP {

CI

EP {

CI

ST

## FIG. 8H

C1  EF

CI

EP {

CI

EP {

CI

ST

## FIG. 8I

FIG. 8J

FIG. 8K

FIG. 9A

FIG. 9B

C1   EF'

CI

EP {

CI

EP {

CI

ST

FIG. 9C

C1        EF

CI

EP {

CI

EP {

CI

ST

FIG. 9D

CI

C1  C2          EF

EP {

CI

EP {

CI

ST

FIG. 9E

C1  C2  EV    EF

CI

EP {

CI

EP {

CI

ST

FIG. 9F

PRO

FIG. 10

```
┌─────────────┐              ┌─────────────┐
│     D1      │              │     D4      │
└─────────────┘              └─────────────┘
       │                            │
       ▼                            ▼
┌─────────────┐              ┌─────────────┐
│     D2      │              │     D5      │
└─────────────┘              └─────────────┘
       │                            │
       ▼                            ▼
┌─────────────┐              ┌─────────────┐
│     AG1     │              │     AG3     │
└─────────────┘              └─────────────┘
       │                            │
       ▼                            ▼
┌─────────────┐              ┌─────────────┐
│     SG1     │              │     SG2     │
└─────────────┘              └─────────────┘
       │                            │
       ▼                            ▼
┌─────────────┐              ┌─────────────┐
│     D3      │              │     D6      │
└─────────────┘              └─────────────┘
       │                            │
       ▼                            ▼
┌─────────────┐              ┌─────────────┐
│     AG2     │              │     D7      │
└─────────────┘              └─────────────┘
                                    │
                                    ▼
                             ┌─────────────┐
                             │     AG4     │
                             └─────────────┘
```

FIG. 11A

CI'
CI
ST

FIG. 11B

FIG. 11C

CI
CI'
CI
CI'
CI
ST

FIG. 11D

OUV

CI
CI'
CI
CI'
CI
ST

FIG. 11E

CAV

CI

CI'

CI

CI'

CI

ST

FIG. 11F

EF'

CI

CI'

CI

CI'

CI

ST

FIG. 11G

EF

CI
CI'
CI
CI'
CI
ST

**FIG. 11H**

EF    C2    EF

CI
CI'
CI
CI'
CI
ST

**FIG. 11I**

EF   EV   C2   EF

CI

CI'

CI

CI'

CI

ST

## FIG. 11J

EF   EV   C2   EF   TR

CI

CI'

CI

CI'

CI

ST

## FIG. 11K

CAV      EF   EV   C2    EF

## FIG. 11L

C1      EF   EV   C2    EF

## FIG. 11M

EP'  C1        EF  EV  C2      EF

## FIG. 11N

C1      EF  EV  C2      EF

EP'

## FIG. 11O

PRO

FIG. 12

```
      D1
       │
       ▼
      D2
       │
       ▼
      AG1
       │
       ▼
      SG1
       │
       ▼
      D3
       │
       ▼
      D4 ──────────┐
                   │
   ┌───────────────┘
   │
   └──────────────► AG2
                     │
                     ▼
                    D5
                     │
                     ▼
                    D6
                     │
                     ▼
                    AG3
                     │
                     ▼
                    SG2
                     │
                     ▼
                    D7
                     │
                     ▼
                    AG4
```

FIG. 13A

FIG. 13B

FIG. 13C

FIG. 13D

FIG. 13E

CAV

CI

CI'

CI

CI'

CI

ST

## FIG. 13F

C1

CI

CI'

CI

CI'

CI

ST

## FIG. 13G

C1   EF'

CI

CI'

CI

CI'

CI

ST

FIG. 13H

C1  EF'

CI

CI'

CI

CI'

CI

ST

FIG. 13I

C1 EF'  C2

CI

CI'

CI

CI'

CI

ST

FIG. 13J

C1 EF'  EV  C2

CI

CI'

CI

CI'

CI

ST

FIG. 13K

FIG. 13L

FIG. 13M

EP'　　　C1　　EV C2　　EF

## FIG. 13N

EP　　C1　　EV C2　　EF

## FIG. 13O

FIG. 14A

FIG. 14B

FIG. 15A

FIG. 15B

## RÉFÉRENCES CITÉES DANS LA DESCRIPTION

**Documents brevets cités dans la description**

- WO 2016160233 A
- WO 2017111776 A
- WO 2017131642 A
- US 2015340406 A